(19) Europäisches Patentamt
European Patent Office
Office européen des brevets

(11) **EP 4 760 782 A1**

(12) **EUROPEAN PATENT APPLICATION**
published in accordance with Art. 153(4) EPC

(43) Date of publication:
**17.06.2026 Bulletin 2026/25**

(21) Application number: **24851804.5**

(22) Date of filing: **05.08.2024**

(51) International Patent Classification (IPC):
***H01L 23/29*** *(2006.01)* ***H01L 23/31*** *(2006.01)*
***C08F 32/08*** *(2006.01)* ***C08F 290/14*** *(2006.01)*
***C08G 8/30*** *(2006.01)* ***C09K 3/10*** *(2006.01)*

(52) Cooperative Patent Classification (CPC):
**C08F 32/08; C08F 290/14; C08G 8/30; C09K 3/10; H10W 74/10; H10W 74/40**

(86) International application number:
**PCT/JP2024/027905**

(87) International publication number:
**WO 2025/033380 (13.02.2025 Gazette 2025/07)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.08.2023 JP 2023128624**

(71) Applicant: **Resonac Corporation**
**Tokyo 105-7325 (JP)**

(72) Inventors:
- **NAGASHIMA Kazushi**
  **Tokyo 105-7325 (JP)**
- **YAMAURA Masashi**
  **Tokyo 105-7325 (JP)**

(74) Representative: **Hoffmann Eitle**
**Patent- und Rechtsanwälte PartmbB**
**Arabellastraße 30**
**81925 München (DE)**

(54) **SEALING MATERIAL, SEALING MEMBER, AND SEMICONDUCTOR DEVICE**

(57) The present disclosure relates to a sealing material containing a compound having a structural unit represented by the following formula (Bb1). In formula (Bb1), $X^E$ represents an aromatic ring-containing organic group, wherein the organic group does not contain a structure represented by the following formula (X1) or (X2)), each B independently represents a vinyl phenyl group-containing group, each R independently represents a substituent, l represents an integer of 1 to 5, and m represents an integer of 0 to 10.

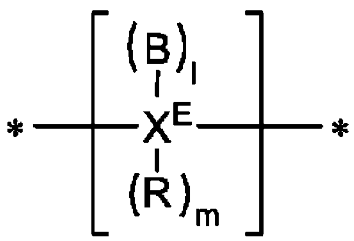

(Bb1)

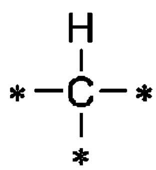

(X1)

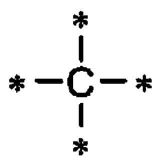

(X2)

EP 4 760 782 A1

Processed by Luminess, 75001 PARIS (FR)

## Description

### Technical Field

The present disclosure relates to a sealing material, a sealing member, an electronic component device, a semiconductor device, and a semiconductor module.

### Related Art

Semiconductor devices are used in various electronic equipment. As electronic equipment becomes smaller, lighter, and more functional, the amount of heat generated in semiconductor devices that handle high-speed, large-capacity information is increasing. In addition, in recent years, semiconductor devices are increasingly being used in high-current or high-voltage environments such as automobiles, trains, wind power generation, and solar power generation. The higher the current or voltage, the greater the amount of heat generated by the semiconductor device. Along with these trends, the heat resistance of semiconductor devices has become increasingly important.

In semiconductor devices, cured products of thermosetting resin compositions comprising an epoxy resin, a curing agent, and an inorganic filler are widely used as sealing members for semiconductor elements from the viewpoint of productivity, cost, and the like (see Patent Document 1). In order to improve the heat resistance of semiconductor devices, sealing members are also required to have superior heat resistance.

### Prior Art Documents

### Patent Documents

Patent Document 1: Japanese Patent Laid-Open No. 2021-130743

## SUMMARY OF INVENTION

### Problems to Be Solved by the Invention

The present disclosure provides a sealing material capable of obtaining a sealing member having excellent heat resistance. The present disclosure also provides a sealing member having excellent heat resistance. Furthermore, the present disclosure provides an electronic component device, a semiconductor device, and a semiconductor module having excellent heat resistance. Means for Solving the Problems

The present invention includes the following embodiments. The present invention is not limited to the following embodiments. One embodiment relates to a sealing material comprising a compound having a structural unit represented by the following formula (Bb1).

[Chem. 1]

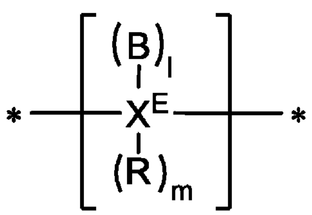

(Bb1)

(In the formula, $X^E$ represents an aromatic ring-containing organic group (wherein the organic group does not contain a structure represented by the following formula (X1) or (X2)), each B independently represents a vinyl phenyl group-containing group, each R independently represents a substituent, 1 represents an integer of 1 to 5, and m represents an integer of 0 to 10. * represents a bonding position with another atom.)

[Chem. 2]

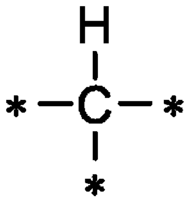

(X1)

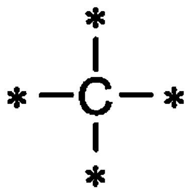

(X2)

(In the formula, * represents a bonding position with an atom other than a hydrogen atom.))

Another embodiment relates to a sealing member comprising a cured product obtained using the sealing material. Another embodiment relates to an electronic component device comprising the sealing member. Another embodiment relates to a semiconductor device comprising a semiconductor element and the sealing member sealing at least a part of the semiconductor element. Another embodiment relates to a semiconductor module having a plurality of members selected from the group consisting of semiconductor elements and semiconductor devices, and the sealing member sealing at least a part of the plurality of members.

Effects of the Invention

According to the present disclosure, a sealing material capable of obtaining a sealing member having excellent heat resistance is provided. Also, according to the present disclosure, a sealing member having excellent heat resistance is provided. Furthermore, according to the present disclosure, an electronic component device, a semiconductor device, and a semiconductor module having excellent heat resistance are provided.

DESCRIPTION OF THE EMBODIMENTS

Embodiments of the present invention will be described. The present invention is not limited to the following embodiments. The following embodiments can be implemented alone or in combination. Combinations of multiple embodiments are also included in the present invention.

In the present disclosure, a numerical range indicated using "to" means a range including the numerical values described before and after "to" as the minimum value and the maximum value, respectively.

In the numerical range described stepwise in the present disclosure, the upper limit value or the lower limit value of a certain numerical range may be replaced with the upper limit value or the lower limit value of another numerical range. The upper limit value or the lower limit value of the numerical range described in the present disclosure may be replaced with the value shown in the Examples.

A certain numerical value may be selected from each of the upper limit numerical values and the lower limit numerical values described stepwise in the present disclosure to constitute a stepwise numerical range. The upper limit numerical values and the lower limit numerical values described in the present disclosure may be replaced with the values shown in the Examples.

In the present disclosure, each component may comprise multiple types of corresponding substances. In the case where multiple types of substances corresponding to each component are present in the composition, the content ratio or content of each component means the total content ratio or content of the multiple types of substances present in the composition, unless otherwise specified.

In the present disclosure, each structure in a polymer may comprise multiple types of corresponding structures. In the case where multiple types of structures corresponding to each structure are present in the polymer, the content ratio or content of each structure means the total content ratio or content of the multiple types of structures present in the polymer, unless otherwise specified.

In the present disclosure, particles corresponding to each component may comprise multiple types of particles. In the case where multiple types of particles corresponding to each component are present in the composition, the particle diameter of each component means a value for the mixture of the multiple types of particles present in the composition, unless otherwise specified.

<Sealing Material>

The sealing material comprises at least a compound having a structural unit represented by formula (Bb1). In the present disclosure, a compound having a structural unit represented by formula (Bb1) may be referred to as a "compound having a vinyl phenyl group" or a "vinylphenyl compound." The sealing material may further comprise a compound having a vinyl group. In the present disclosure, the compound having a vinyl group is a compound different from the compound having a vinyl phenyl group, and is a compound that does not correspond to the compound having a vinyl phenyl group. The compound having a vinyl group does not have a vinyl phenyl group. The compound having a vinyl group may be a compound not having a vinyl phenyl group. In the present disclosure, the compound having a vinyl group may be referred to as a "vinyl compound".

A cured product obtained using the sealing material can be used as a sealing member for sealing electronic components such as semiconductor elements. The sealing material may be a composition for a sealing member, and the composition for sealing member comprises multiple types of compounds. In some embodiments, the sealing material is a radical-polymerizable sealing material that can polymerize by radical polymerization to form a cured product. The sealing material may be a radically polymerizable composition, and the radically polymerizable composition comprises multiple types of compounds.

[Compound having a vinyl phenyl group]

The vinylphenyl compound is a compound having a structural unit represented by formula (Bb1), and has at least one vinyl phenyl group. The vinylphenyl compound has, for example, 1 to 20, 1 to 15, or 1 to 10 vinyl phenyl groups. The vinylphenyl compound may consist of one type of vinylphenyl compound or may comprise two or more types of vinylphenyl compounds. In the case where the sealing material comprises the vinylphenyl compound, the heat resistance of the cured product is improved. One of the reasons for this is that the vinylphenyl compound has high reactivity. In the case where the vinylphenyl compound having high reactivity, the curing reaction of the sealing material tends to proceed sufficiently. As a result, the crosslinking density of the obtained cured product becomes high, thereby increasing the thermal decomposition temperature and improving the heat resistance. In addition, in the case where the crosslinking density becoming high, an effect is also obtained in which the amount of expansion of the cured product accompanying temperature rise becomes small. In the case where the amount of expansion being small, warpage of the electronic component device can be suppressed. However, these are speculations, and the present invention is not limited by these speculations.

The vinyl phenyl group can be represented by any of the following formulas. From the viewpoint of obtaining a cured product having low dielectric constant and low dissipation factor, the vinylphenyl compound may comprise a compound having a group represented by formula (p). * represents a bonding position with other atoms.

[Chem. 3]

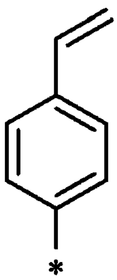

(p)

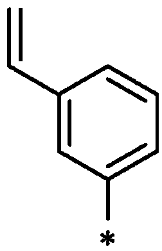

(m)

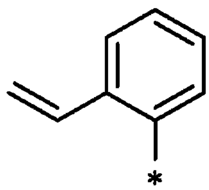

(o)

In the total amount of the vinylphenyl compound contained in the sealing material, the ratio of the group represented by formula (p), the group represented by formula (m), and the group represented by formula (o) (molar ratio of the group represented by formula (p):the group represented by formula (m):the group represented by formula (o)) is, for example, 40 to 100:0 to 60:0 to 60, 70 to 90:0:10 to 30, or 40 to 60:40 to 60:0. The larger the ratio of the group represented by formula (p), the lower the dielectric constant and dissipation factor of the cured product tend to be.

The vinylphenyl compound may be a compound having a vinylphenylmethyl group (also referred to as "vinyl benzyl group"). In the present disclosure, a compound having a vinyl benzyl group may be referred to as a "vinylbenzyl compound". The vinylbenzyl compound corresponds to an example of the vinylphenyl compound. The vinylphenyl compound may be a compound having a vinylphenylmethyloxy group (also referred to as "vinyl benzyl ether group"). In the

present disclosure, a compound having a vinyl benzyl ether group may be referred to as a "vinylbenzylether compound". The vinylbenzylether compound corresponds to examples of the vinylbenzyl compound and the vinylphenyl compound.

The vinylphenyl compound may be a radical-polymerizable monomer or polymer. The vinylphenyl compound comprises, for example, a monomer having a vinyl phenyl group. In the present disclosure, a monomer having a vinyl phenyl group may be referred to as a "vinyl phenyl group-containing monomer". The vinylphenyl compound comprises, for example, a polymer having a vinyl phenyl group. In the present disclosure, a polymer having a vinyl phenyl group may be referred to as a "vinyl phenyl group-containing polymer". In the present disclosure, a monomer may be a compound having one structural unit represented by formula (Bb1) and not containing repeats of the structural unit represented by formula (Bb1). A polymer may be a compound having two or more structural units represented by formula (Bb1) and containing a repeat of the structural unit represented by formula (Bb1). The polymer may be a polymer with a low degree of polymerization (i.e., an oligomer) or a polymer with a high degree of polymerization.

In some embodiments, the vinylphenyl compound comprises a compound having two vinyl phenyl groups. The compound having two vinyl phenyl groups may be a monomer or a polymer. In some embodiments, the vinylphenyl compound comprises a compound having three or more vinyl phenyl groups. The compound having three or more vinyl phenyl groups may be a monomer or a polymer.

The sealing material contains a compound having a structural unit represented by the following formula (Bb1).

[Chem. 4]

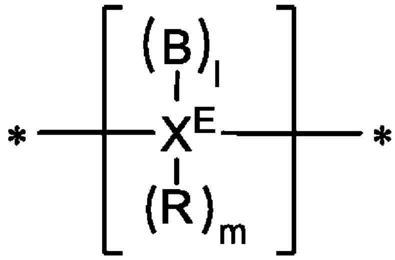

(Bb1)

(In the formula, $X^E$ represents an aromatic ring-containing organic group (wherein the organic group does not contain a structure represented by the following formula (X1) or (X2)), l represents an integer of 1 to 5, each B independently represents a vinyl phenyl group-containing group, each R independently represents a substituent, m represents an integer of 0 to 10. * represents a bonding position with another atom.

[Chem. 5]

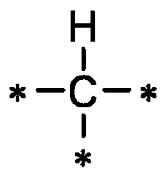

(X1)

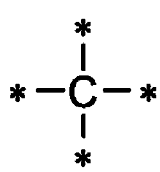

(X2)

(In the formula, * represents a bonding position with an atom other than a hydrogen atom.))

The term "each...independently" for B means that, for example, when 1 is 2 or more and the structural unit represented by formula (Bb1) has multiple B, the multiple B may be the same "vinyl phenyl group-containing group" or may be partially or entirely different "vinyl phenyl group-containing groups" from each other. The term "each... independently" in this case does not preclude 1 from being 1, and the structural unit represented by formula (Bb1) may be a structural unit having one "vinyl phenyl group-containing group". The same applies to descriptions similar to "$(B)_1$" in the present disclosure.

Examples of $X^E$ comprise "$X^{b2}$" and "$Y^E$-$X^{B4}$" described later (wherein $X^E$ does not contain a structure represented by formula (X1) or (X2)). Examples of compounds having a structural unit represented by formula (Bb1) include compounds represented by formula (b2) described later and polymers represented by formula (B4) described

later. In the compounds represented by formula (b2) described later and the polymers represented by formula (B4) described later, the structure represented by formula (X1) or (X2) may be contained as a part constituting a ring of a condensed polycyclic aromatic ring. That is, in the aromatic ring-containing organic group that is $X^E$ (wherein the organic group does not contain a structure represented by formula (X1) or (X2)), when $X^E$ contains a condensed polycyclic aromatic ring, the condensed polycyclic aromatic ring can contain a structure represented by formula (X1) or (X2) as a part constituting a ring.

(Vinyl phenyl group-containing monomer)

In some embodiments, the vinylphenyl compound comprises a vinyl phenyl group-containing monomer having one structural unit represented by formula (Bb1). The vinyl phenyl group-containing monomer comprises a monomer having two vinyl phenyl groups, and may further comprise at least one selected from the group consisting of a monomer having one vinyl phenyl group and a monomer having three vinyl phenyl groups; or may comprise a monomer having two vinyl phenyl groups, a monomer having one vinyl phenyl group, and a monomer having three vinyl phenyl groups. When the vinyl phenyl group-containing monomer comprises two or more types of vinyl phenyl group-containing monomers, the average number of vinyl phenyl groups that the vinyl phenyl group-containing monomer has is, for example, 1.2 to 2.8, 1.4 to 2.7, or 1.6 to 2.6.

The vinyl phenyl group-containing monomer may further have an aromatic ring. The vinyl phenyl group-containing monomer may have only one aromatic ring, or may have two or more aromatic rings. The number of carbon atoms of the aromatic ring may be, for example, 2 to 30, 6 to 20, or 9 to 15. The aromatic ring may be an aromatic hydrocarbon ring or an aromatic heterocyclic group. The aromatic ring may be a monocyclic ring or a condensed polycyclic ring. Examples of the aromatic hydrocarbon ring comprise: benzene, naphthalene, anthracene, tetracene, fluorene, phenanthrene, indene, indane, biphenylene, and the like. Examples of the aromatic heterocyclic group comprise: pyridine, pyrazine, quinoline, isoquinoline, acridine, phenanthroline, furan, pyrrole, thiophene, carbazole, oxazole, oxadiazole, thiadiazole, triazole, benzoxazole, benzoxadiazole, benzothiadiazole, benzotriazole, benzothiophene, and the like. From the viewpoint of dielectric properties of the cured product, the aromatic ring may be an aromatic hydrocarbon ring, and may be a condensed polycyclic aromatic hydrocarbon ring. From the viewpoint of dielectric constant and dissipation factor, the aromatic ring may be, for example, fluorene or indene; or may be indene. In the case where the vinyl phenyl group-containing monomer comprises indene, there is a tendency that a cured product exhibiting lower dielectric constant and dissipation factor can be obtained.

The aromatic ring, the aromatic hydrocarbon ring and the aromatic heterocyclic group which are examples of the aromatic ring, the condensed polycyclic aromatic hydrocarbon ring, and the rings specifically listed above may all be substituted or unsubstituted. Examples of the substituent in the case where substitution comprise: an alkyl group, an alkenyl group, an aryl group, a heteroaryl group, a monovalent group formed by bonding two or more selected from these, and the like. The number of carbon atoms of the alkyl group and the alkenyl group may be 1 to 18, 2 to 12, or 3 to 6. The number of carbon atoms of the aryl group and the heteroaryl group may be 2 to 30, 6 to 20, or 9 to 15. Examples of the monovalent group comprise: an alkylaryl group, an arylalkyl group, an alkylarylalkyl group, and the like.

The vinyl phenyl group-containing monomer may comprise, for example, a monomer having one aromatic ring and 1 to 3 vinyl phenyl groups bonded to the aromatic ring directly or via a linking group; may comprise a monomer having one aromatic hydrocarbon ring and 1 to 3 vinyl phenyl groups bonded to the aromatic hydrocarbon ring directly or via a linking group; or may comprise a monomer having one indene ring and 1 to 3 vinyl phenyl groups bonded to the indene ring directly or via a linking group. In these embodiments, each of the aromatic ring, the aromatic hydrocarbon ring, and the indene ring may be substituted or unsubstituted. Examples of the substituent are as described above. The linking group may be, for example, a group selected from the group consisting of an alkylene group (the number of carbon atoms is, for example, 1 to 5), an oxy group, a thio group, a sulfonyl group, a sulfinyl group, a carbonyl group, a carbonyloxy group, an imino group, and a divalent group formed by bonding two or more selected from these. Note that "having one aromatic ring and 1 to 3 vinyl phenyl groups bonded to the aromatic ring via a linking group" means "having one aromatic ring and 1 to 3 of 'a linking group bonded to the aromatic ring and a vinyl phenyl group bonded to the linking group'".

The organic group that the vinyl phenyl group-containing monomer has, may have, instead of the aromatic ring or in combination with the aromatic ring, a saturated or unsaturated aliphatic hydrocarbon group, a saturated or unsaturated alicyclic hydrocarbon group, a group comprises a heteroatom, and the like.

The weight average molecular weight (Mw) of the vinyl phenyl group-containing monomer is, for example, 200 to 2000, 200 to 1000, 200 to 800, 250 to 750, or 300 to 700, from the viewpoint of moldability and handleability. In the present disclosure, the weight average molecular weight (Mw) and the number average molecular weight (Mn) mean values measured in terms of polystyrene by gel permeation chromatography (GPC). Specifically, the weight average molecular weight (Mw) and the number average molecular weight (Mn) in the present disclosure can be measured by the method described in Examples.

**In** some embodiments, the vinylphenyl compound comprises a compound represented by the following formula

(b2). In the case where the vinylphenyl compound comprises a compound represented by the following formula (b2), superior heat resistance tends to be obtained, and the amount of expansion also tends to be smaller.

[Chem. 6]

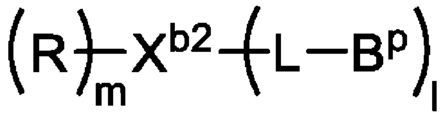

(b 2)

(In the formula, $X^{b2}$ represents an aromatic hydrocarbon ring group, each $B^p$ independently represents a group represented by the following formula (Ph), each L independently represents a direct bond or a linking group, l represents an integer of 1 to 3, each R independently represents a substituent, and m represents an integer of 0 to 3.

[Chem. 7]

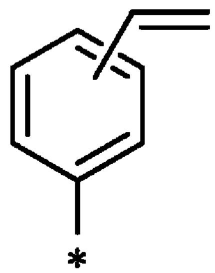

(P h)

(In the formula, * represents a bonding position.))

Examples of the aromatic hydrocarbon ring in the aromatic hydrocarbon ring group are as described above. $X^{b2}$ may be, for example, a condensed polycyclic aromatic hydrocarbon ring group.

Examples of the linking group are as described above. The linking group may be, for example, an alkylene group (the number of carbon atoms is, for example, 1 to 5), and may be a methylene group. Note that L being a "direct bond" means that $X^{b2}$ and $B^p$ are directly bonded. The same applies to similar descriptions in the present disclosure regarding "L is a direct bond."

The vinyl phenyl group-containing monomer comprises, for example, a compound in which 1 is 2 in formula (b2), and may further comprise at least one selected from the group consisting of a compound in which l is 1 and a compound in which l is 3; or may comprise a compound in which l is 2, a compound in which l is 1, and a compound in which l is 3. In the case where the vinyl phenyl group-containing monomer comprises multiple types of compounds represented by formula (b2), the average value of l in the compounds represented by formula (b2) is, for example, 1.2 to 2.8, 1.4 to 2.7, or 1.6 to 2.6.

Examples of the substituent represented by R comprise: an alkyl group, an alkenyl group, an aryl group, a heteroaryl group, and a monovalent group formed by bonding two or more selected from these. The alkyl group and the alkenyl group may have 1 to 18, 2 to 12, or 3 to 6 carbon atoms. The aryl group and the heteroaryl group may have 2 to 30, 6 to 20, or 9 to 15 carbon atoms. Examples of the monovalent group comprise: an alkylaryl group, an arylalkyl group, an alkylarylalkyl group, and the like. m may be 0 to 2, or 0 or 1. In the case where the vinyl phenyl group-containing monomer includes multiple types of compounds represented by formula (b1), the average value of m in the compounds represented by formula (b2) is, for example, 0.0 to 1.8, 0.0 to 1.6, or 0.0 to 1.4. In some embodiments, the average value of m may be more than 0.0, 0.1 or more, 0.5 or more, or 1.0 or more.

From the viewpoint of obtaining a cured product having low dielectric constant and low dissipation factor, the group represented by formula (Ph) may comprise the group represented by formula (p) above.

In some embodiments, the vinylphenyl compound comprises a compound represented by the following formula (b3). In the case where the vinylphenyl compound comprises a compound represented by the following formula (b3), superior heat resistance tends to be obtained, the amount of expansion tends to become smaller, and furthermore, low dielectric constant and low dissipation factor tend to be obtained.

[Chem. 8]

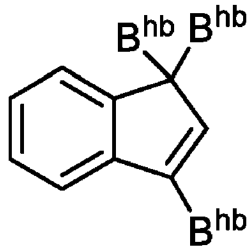

(b 3)

(In the formula, each $B^{hb}$ independently represents a hydrogen atom, a group represented by the following formula (Ba), or a group represented by the following formula (Bz), and at least one $B^{hb}$ is a group represented by the following formula (Bz).

[Chem. 9]

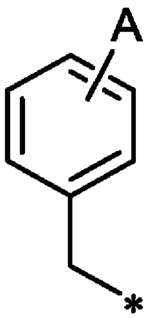

(B a)

(In the formula, A represents an alkyl group, and * represents a bonding position.)

[Chem. 10]

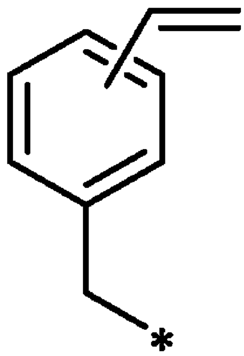

(B z)

(In the formula, * represents a bonding position.))

The number of carbon atoms of the alkyl group represented by A is, for example, 1 to 6.

The vinyl phenyl group-containing monomer comprises a compound in which the number of groups represented by formula (Bz) in formula (b3) is 2, and may further comprise at least one selected from the group consisting of a compound in which the number is 1 and a compound in which the number is 3; or may comprise a compound in which the number of groups represented by formula (Bz) is 2, a compound in which the number is 1, and a compound in which the number is 3. In the case where the vinyl phenyl group-containing monomer comprises multiple types of compounds

represented by formula (b3), the average number of groups represented by formula (Bz) that the compound represented by formula (b3) has is, for example, 1.2 to 2.8, 1.4 to 2.7, or 1.6 to 2.6. The average number of groups represented by formula (Ba) in the compound represented by formula (b3) is, for example, 0.0 to 1.8, 0.0 to 1.6, or 0.0 to 1.4. In some embodiments, the average number of groups represented by formula (Ba) may be more than 0.0, 0.1 or more, 0.5 or more, or 1.0 or more.

From the viewpoint of obtaining a cured product having low dielectric constant and low dissipation factor, the group represented by formula (Bz) may comprise a group represented by formula (Bz) in which the bonding position of the vinyl group to the benzene ring is at the para position relative to the bonding position of the methylene group to the benzene ring.

The method for synthesizing the vinyl phenyl group-containing monomer is not particularly limited. For example, in the case where the vinyl phenyl group-containing monomer is a compound represented by formula (b2), a method may be listed in which an aromatic hydrocarbon ring and a styrene having a halogenated methyl group are reacted in the presence of a basic compound. In the case where being synthesized by this method, the compound represented by formula (b2) has a methylene group as a linking group.

Examples of the styrene having a halogenated methyl group comprise o-chloromethylstyrene, m-chloromethylstyrene, p-chloromethylstyrene, and the like, and these can be used alone or in a mixture of two or more. Examples of the basic compound comprise alkali metal hydroxides, alkali metal alkoxides, and the like. A phase transfer catalyst may be used in this reaction. Examples of the phase transfer catalyst comprise tetrabutylphosphonium bromide, tetra-n-butylammonium bromide, and the like. The reaction can be performed in a solvent. The reaction may be performed under heating and stirring. A polymerization inhibitor may be added to the reaction system. The obtained product may be purified by known methods such as concentration, reprecipitation, washing, and the like, as necessary.

(Vinyl phenyl group-containing polymer)

In some embodiments, the vinylphenyl compound comprises a vinyl phenyl group-containing polymer having two or more structural units represented by formula (BX). The vinylphenyl compound may comprise a polymer having two vinyl phenyl groups; or may comprise a polymer having three or more vinyl phenyl groups. Examples of the vinyl phenyl group-containing polymer comprise a polymer having a phenolic resin-type skeleton and having a vinyl phenyl group, and the like. Examples of the phenolic resin comprise: Novolac type phenolic resin, aralkyl type phenolic resin, dicyclopentadiene type phenolic resin, triphenylmethane type phenolic resin, and resins comprises a naphthol structure instead of or in combination with a phenol structure in these phenolic resins, and the like.

From the viewpoint of moldability and handleability, the weight average molecular weight (Mw) of the vinyl phenyl group-containing polymer is, for example, 300 to 50000, 500 to 30000, or 1000 to 10000. From the viewpoint of improving the flowability of the sealing material and obtaining good moldability, the weight average molecular weight (Mw) may be 5000 or less, or 2500 or less.

In some embodiments, the vinylphenyl compound comprising a polymer comprises a structure represented by the following formula (B4). In the case where the vinylphenyl compound includes a polymer represented by the following formula (B4), superior heat resistance tends to be obtained, and the amount of expansion also tends to be smaller.

[Chem. 11]

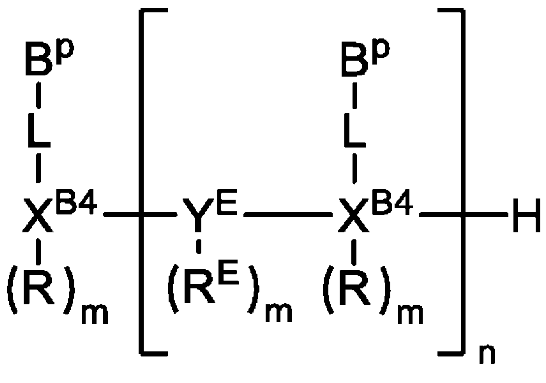

(B4)

(In the formula, $X^{B4}$ each independently represents a benzene ring or a naphthalene ring, each $Y^{E}$ independently represents a group represented by any one of the following formulas (Y1) to (Y4), each $B^{p}$ independently represents a

group represented by the following formula (Ph), each L independently represents a direct bond or a linking group, each R independently represents a substituent, each $R^E$ independently represents a substituent bonded to a benzene ring or a naphthalene ring, each m independently represents an integer of 0 to 5, and n represents a number of 2 to 10.)

[Chem. 12]

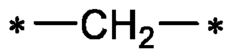
(Y 1)

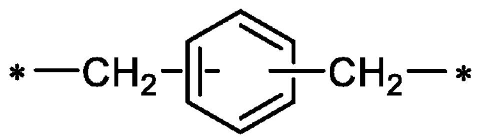
(Y 2)

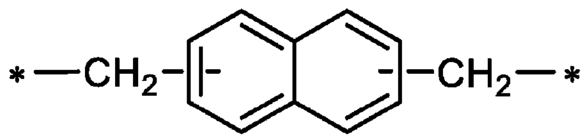
(Y 3)

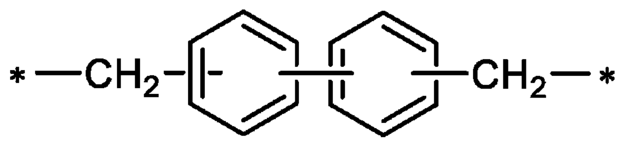
(Y 4)

(In each formula, * represents a bonding position, and each of the benzene ring and the naphthalene ring may independently have a substituent at a substitutable position.)

[Chem. 13]

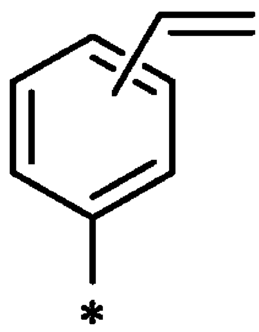
(P h)

(In the formula, * represents a bonding position.)

From the viewpoint of obtaining a cured product having low dielectric constant and low dissipation factor, the group represented by the formula (Ph) may comprise the group represented by the above formula (p).

Examples of the linking group comprise an alkylene group (the number of carbon atoms is, for example, 1 to 5), an oxy group, a thio group, a sulfonyl group, a sulfinyl group, a carbonyl group, a carbonyloxy group, an imino group, and a divalent group formed by bonding two or more selected from these.

Examples of the substituent include an alkyl group having 1 to 5 carbon atoms such as a methyl group, an ethyl group, an n-propyl group, an isopropyl group, an n-butyl group, an isobutyl group, a t-butyl group, and an n-pentyl group. In the case where the number of carbon atoms is 3 or more, the alkyl group may be a linear alkyl group. The substituent may be an alkyl group having 1 to 5 carbon atoms, and may be a methyl group. Each m independently represents, for example,

an integer of 0 to 4, an integer of 0 to 2, or 0.

n is an average value in the polymer represented by the formula (B4). n represents, for example, a number of 2 to 8, or a number of 3 to 5.

In some embodiments, the vinylphenyl compound may comprise at least one selected from the group consisting of polymers represented by the following formulas.

[Chem. 14-1]

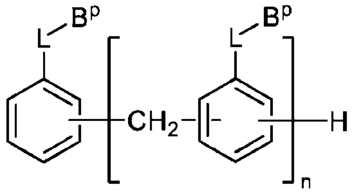

（B 2－1）

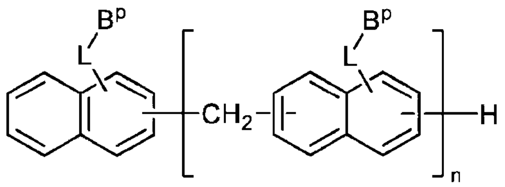

（B 2－2）

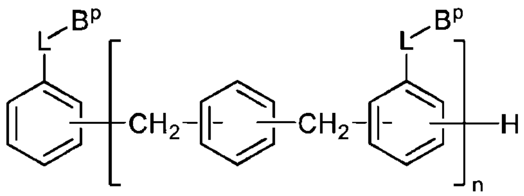

（B 2－3）

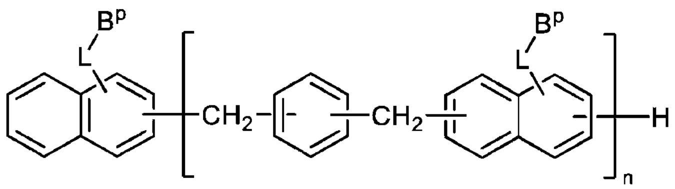

（B 2－4）

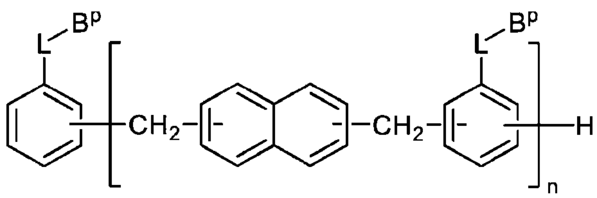

（B 2－5）

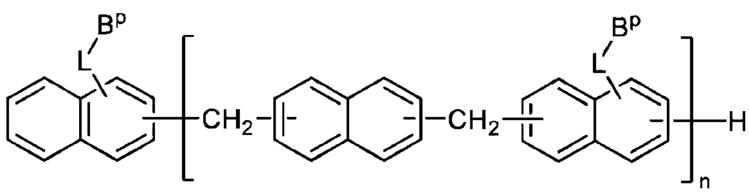

（B 2－6）

[Chem. 14-2]

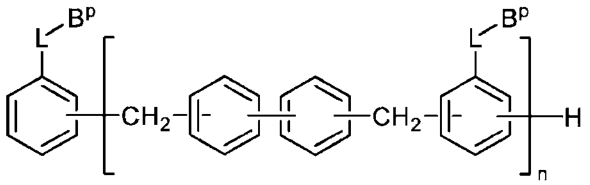

(B2-7)

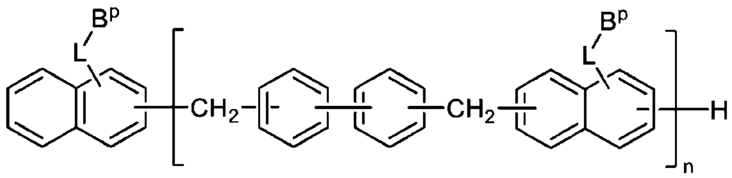

(B2-8)

(In each formula, each $B^p$ independently represents a group represented by the above formula (Ph), each L independently represents a direct bond or a linking group, and n represents a number of 2 to 10. Each of the benzene ring and the naphthalene ring may independently have a substituent at substitutable positions.)

From the viewpoint of obtaining a cured product having low dielectric constant and low dissipation factor, the group represented by the formula (Ph) may comprise the group represented by the above formula (p).

Examples of the linking group are as listed in the formula (B4). The linking group may comprise an oxy group from the viewpoint of obtaining good tracking resistance. The linking group comprises, for example, a methyleneoxy group, and in that case, the polymer represented by the above formula comprises a structure represented by $B^P$-$CH_2$-O-*.

When the benzene ring and the naphthalene ring in each formula have a substituent, examples of the substituent are as listed for R in the formula (B4). The substituent may be an alkyl group having 1 to 5 carbon atoms, and may be a methyl group. In the case where the number of carbon atoms is 3 or more, the alkyl group may be a linear alkyl group. Alternatively, the benzene ring and the naphthalene ring in each formula may be unsubstituted, or may have no substituent other than $B^P$-L-*.

n is an average value in the polymer represented by each formula. n represents, for example, a number of 2 to 8, or a number of 3 to 5.

When the vinylphenyl compound comprises at least one selected from the group consisting of the polymer represented by the formula (B2-1) to the polymer represented by the formula (B2-8), excellent heat resistance is easily obtained, and the amount of expansion also tends to be small. When the vinylphenyl compound comprises at least one selected from the group consisting of the polymer represented by the formula (B2-3) and the polymer represented by the formula (B2-7), low dielectric constant and dissipation factor are easily obtained. In particular, when the vinylphenyl compound comprises the polymer represented by the formula (B2-3), lower dielectric constant and dissipation factor tend to be obtained.

In some embodiments, the vinylphenyl compound comprises a polymer represented by the following formula (B3-3), a polymer represented by the following formula (B3-7), or both of these.

[Chem. 15]

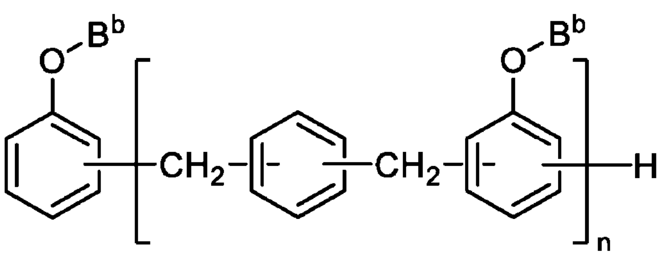

(B3-3)

(In the formula, each $B^b$ independently represents a group represented by the following formula (Bz), and n represents a number of 3 to 5.)

[Chem. 16]

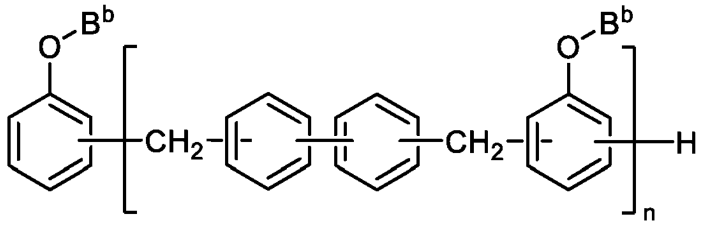

(B3-7)

(In the formula, each $B^b$ independently represents a group represented by the following formula (Bz), and n represents a number of 3 to 5.)

[Chem. 17]

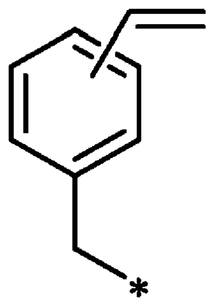

(Bz)

(In the formula, * represents a bonding position.)

From the viewpoint of obtaining a cured product having low dielectric constant and low dissipation factor, the group represented by formula (Bz) may comprise a group represented by formula (Bz) in which the bonding position of the vinyl group to the benzene ring is at the para position relative to the bonding position of the methylene group to the benzene ring.

The method for synthesizing the vinyl phenyl group-containing polymer is not particularly limited. For example, in the case where the vinyl phenyl group-containing polymer is a compound represented by formula (B4), a method of reacting a phenolic resin with a styrene having a halogenated methyl group in the presence of a basic compound may be listed. In the case of being synthesized by this method, the compound represented by formula (B4) has a methyleneoxy group as a linking group.

Examples of the styrene having a halogenated methyl group, the basic compound, and the phase transfer catalyst are as described above. The reaction can be performed in a solvent. The reaction may be performed under heating and stirring. A polymerization inhibitor may be added to the reaction system. The obtained product may be purified by known methods such as concentration, reprecipitation, and washing, as necessary.

Examples of the phenolic resin comprise: Novolac type phenolic resin, aralkyl type phenolic resin, dicyclopentadiene type phenolic resin, biphenyl type phenolic resin, triphenylmethane type phenolic resin, and resins comprises a naphthol structure instead of or in combination with a phenol structure in these phenolic resins. A commercially available product can be used as the phenolic resin.

The weight average molecular weight (Mw) of the phenolic resin is, for example, 300 to 30000, 500 to 10000, or 1000 to 5000, from the viewpoint of moldability and handleability of the sealing material. The number average molecular weight (Mn) of the phenolic resin is, for example, 200 to 10000, 300 to 5000, or 400 to 1500, from the viewpoint of moldability and handleability. The hydroxyl group equivalent of the phenolic resin is, for example, 50 to 500 g/eq, 100 to 400 g/eq, or 150 to 300 g/eq, from the viewpoint of heat resistance and amount of expansion of the cured product. The hydroxyl group equivalent can be measured by a method in accordance with JIS K 0070:1992.

(Content)

The sealing material may comprise only one type of vinylphenyl compound, or may comprise two or more types of

vinylphenyl compound. The content ratio of the vinylphenyl compound is, for example, 10 to 100 mass%, 15 to 98 mass%, or 20 to 95 mass%, based on the mass of the sealing material (however, in the case where the sealing material comprises a filler, the mass of the filler is excluded). In the case where the content ratio of the vinylphenyl compound is 10 mass% or more, the cured product tends to exhibit better heat resistance and the amount of expansion tends to be smaller. From the viewpoint of obtaining particularly excellent heat resistance, the content ratio of the vinylphenyl compound may be, for example, 70 mass% or more, 80 mass% or more, or 90 mass% or more. Considering the addition of optional components such as a polymerization initiator and a colorant, the content ratio of the vinylphenyl compound may be less than 100 mass%.

In the case where the vinylphenyl compound comprises a vinylbenzyl compound, the content ratio of the vinylbenzyl compound is, for example, 70 mass% or more, 80 mass% or more, or 90 mass% or more, based on the mass of the vinylphenyl compound. The upper limit of the content ratio of the vinylbenzyl compound may be 100 mass%. In the case where the vinylphenyl compound comprises a vinylbenzylether compound, the content ratio of the vinylbenzylether compound is, for example, 70 mass% or more, 80 mass% or more, or 90 mass% or more, based on the mass of the vinylphenyl compound. The upper limit of the content ratio of the vinylbenzylether compound may be 100 mass%. In the case where the sealing material comprises a vinylbenzylether compound, tracking resistance tends to be improved.

In the case where the vinylphenyl compound comprises a vinyl phenyl group-containing monomer and a vinyl phenyl group-containing polymer, the content ratio of the vinyl phenyl group-containing monomer is, for example, 5 to 95 mass%, 50 to 90 mass%, or 70 to 88 mass%, based on the mass of the vinylphenyl compound. The content ratio of the vinyl phenyl group-containing polymer is, for example, 5 to 95 mass%, 10 to 50 mass%, or 12 to 30 mass%, based on the mass of the vinylphenyl compound.

In the case where the sealing material comprises a vinyl compound, the total content ratio of the vinylphenyl compound and the vinyl compound is, for example, 70 to 100 mass%, 80 to 99 mass%, or 90 to 98 mass%, based on the mass of the sealing material (however, in the case where the sealing material comprises a filler, the mass of the filler is excluded). In the case where the total content ratio is 70 mass% or more, the cured product tends to exhibit better heat resistance. Considering the addition of optional components such as a polymerization initiator and a colorant, the total content ratio may be less than 100 mass%.

In the case where the sealing material comprises a vinyl compound, the content ratio of the vinylphenyl compound is, for example, 10 to 90 mass%, 15 to 80 mass%, or 20 to 70 mass%, based on the total mass of the vinylphenyl compound and the vinyl compound. In the case where the content ratio of the vinylphenyl compound is 10 mass% or more, the cured product tends to exhibit better heat resistance, and the amount of expansion also tends to be smaller. From the viewpoint of obtaining a sufficient effect by the vinyl compound, the content ratio of the vinylphenyl compound may be 90 mass% or less, and may be 60 mass% or less, 50 mass% or less, or 45 mass% or less.

[Compound having a vinyl group]

The sealing material may further comprise a vinyl compound. The vinyl compound is a compound having at least one vinyl bond. The vinyl bond may be a radical-polymerizable carbon-carbon unsaturated bond. Examples of the vinyl compound comprise a compound having a vinyl bond as a monovalent group represented by $CH_2$=CH-*, a compound having a vinyl bond as a divalent group represented by *-CH=CH-*, or a compound having both the monovalent group and the divalent group. The vinyl compound has, for example, 1 to 20, 1 to 15, or 1 to 10 vinyl bonds. The vinyl compound may consist of one type of vinyl compound, or may comprise two or more types of vinyl compounds. The vinyl compound may not have a vinyl phenyl group. In the case where the sealing material comprises a vinyl compound, curability becomes good, and a cured product having a high glass transition temperature and excellent heat resistance can be obtained.

The vinyl compound may be a monomer or polymer capable of radical polymerization. The vinyl compound comprises, for example, a monomer having a vinyl bond. In the present disclosure, the monomer having a vinyl bond may be referred to as a "vinyl bond-containing monomer". The vinyl compound comprises, for example, a polymer having a vinyl bond. In the present disclosure, the polymer having a vinyl bond may be referred to as a "vinyl bond-containing polymer".

**In** some embodiments, the vinyl compound comprises a compound having two vinyl bonds. The compound having two vinyl bonds may be a monomer or a polymer. In some embodiments, the vinyl compound comprises a compound having three or more vinyl bonds. The compound having three or more vinyl bonds may be a monomer or a polymer.

Examples of the vinyl bond-containing monomer comprise olefin compounds such as ethylene, propylene, butadiene, isoprene, dimethylbutadiene, chloroprene, and 1,3-pentadiene; (meth)acrylic acid ester compounds such as methyl (meth)acrylate, ethyl (meth)acrylate, butyl (meth)acrylate, 2-ethylhexyl (meth)acrylate, trimethylolpropane di(meth)acrylate, pentaerythritol tetra(meth)acrylate, and bisphenol A diglycidyl ether di(meth)acrylate; carboxyl group-containing vinyl compounds such as (meth)acrylic acid, itaconic acid, maleic acid, and fumaric acid; ester group-containing vinyl compounds such as vinyl acetate and vinyl propionate; halogen-containing vinyl compounds

such as vinyl chloride and vinylidene chloride; nitrile group-containing vinyl compounds such as acrylonitrile and methacrylonitrile; amide group-containing vinyl compounds such as acrylamide, methacrylamide, N-methylolacrylamide, and N-methylolmethacrylamide; maleimide compounds such as maleimide, N-phenylmaleimide, and 4,4'-diphenylmethane bismaleimide; and nitrogen-containing vinyl compounds other than the above such as N-vinylpyrrolidone, 1-vinylimidazole, and vinylcarbazole.

Examples of the vinyl bond-containing polymer comprise a polymer having a hydrocarbon-chain skeleton and having a vinyl bond; a polymer having a phenolic resin-type skeleton and having a vinyl bond; and a polyamide, polyamideimide, or polyimide having a vinyl bond. Examples of the phenolic resin are as listed for the vinyl phenyl group-containing polymer. Examples of the polymer having a hydrocarbon-chain skeleton include polyolefin, vinyl-based polymer, acrylic-based polymer, and polydicyclopentadiene.

(Maleimide compound)

In some embodiments, the vinyl compound comprises a compound having a maleimide group. In the present disclosure, the compound having a maleimide group may be referred to as a "maleimide compound". The maleimide compound is a compound having at least one maleimide group. The maleimide compound has, for example, 1 to 20, 1 to 15, or 1 to 10 maleimide groups. The maleimide compound may consist of one type of maleimide compound, or may comprise two or more types of maleimide compounds. In the case where the sealing material comprises the maleimide compound, curability becomes better, and a cured product having a small amount of expansion can be obtained.

The maleimide group can be represented by the following formula. * represents a bonding position with other atoms.

[Chem. 18]

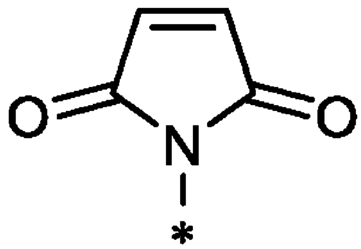

In some embodiments, the maleimide compound comprises a compound having two maleimide groups. In the present disclosure, the compound having two maleimide groups may be referred to as "bismaleimide".

In some embodiments, the vinyl compound comprises a compound represented by the following formula (m1).

[Chem. 19]

$$M-X^m-M \qquad (m1)$$

(In the formula, $X^m$ represents an organic group, and M represents a maleimide group.)

The organic group may be a group comprises at least one carbon atom, and may be, for example, a group comprises at least one selected from the group consisting of a saturated aliphatic hydrocarbon group, an unsaturated aliphatic hydrocarbon group, a saturated alicyclic hydrocarbon group, an unsaturated alicyclic hydrocarbon group, an aromatic hydrocarbon ring group, and an aromatic heterocyclic group. The organic group may or may not further comprise a group comprises a heteroatom. From the viewpoint of improving heat resistance of the cured product, the organic group is preferably a group comprises at least one group selected from the group consisting of an aromatic hydrocarbon ring group and an aromatic heterocyclic group.

In some embodiments, the vinyl compound may comprise at least one selected from the group consisting of compounds represented by the following formulas.

[Chem. 20]

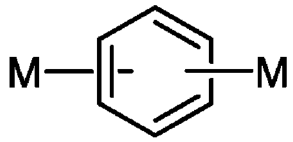

(m−1)

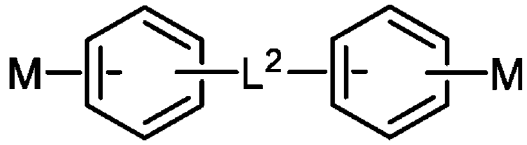

(m−2)

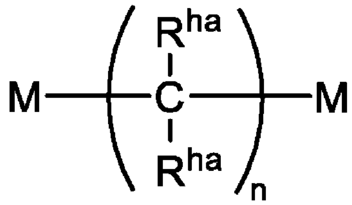

(m−3)

(In each formula, M represents a maleimide group, $L^2$ represents a direct bond or a linking group, each $R^{ha}$ independently represents a hydrogen atom or an alkyl group having 1 to 5 carbon atoms, and n represents an integer of 1 to 8. Each benzene ring may independently have a substituent at substitutable positions.)

Examples of the linking group represented by $L^2$ comprise an alkylene group (having, for example, 1 to 5 carbon atoms), an oxy group, a thio group, a sulfonyl group, a sulfinyl group, a carbonyl group, a carbonyloxy group, an imino group, a group represented by the following formula (m-2L), and the like. Examples of the alkylene group having 1 to 5 carbon atoms comprise linear alkylene groups such as a methylene group, a 1,2-dimethylene group, a 1,3-trimethylene group, a 1,4-tetramethylene group, and a 1,5-pentamethylene group, and branched alkylene groups such as an isopropylene group, an isobutylene group, and a t-butylene group.

[Chem. 21]

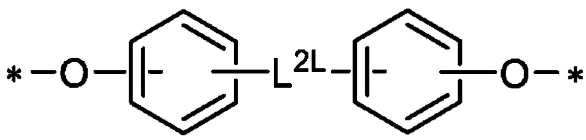

(m−2L)

(In the formula, $L^{2L}$ represents a direct bond or a linking group. Each benzene ring may independently have a substituent at substitutable positions. * represents a bonding position.)

Examples of the linking group represented by $L^{2L}$ comprise an alkylene group (having, for example, 1 to 5 carbon atoms), an oxy group, a thio group, a sulfonyl group, a sulfinyl group, a carbonyl group, a carbonyloxy group, an imino group, and the like. Examples of the alkylene group having 1 to 5 carbon atoms are as listed for $L^2$.

In the above formulas (m-1), (m-2), and (m-2L), each benzene ring is independently unsubstituted or may have a substituent at substitutable positions. Examples of the substituent comprise alkyl groups having 1 to 5 carbon atoms such as a methyl group, an ethyl group, an n-propyl group, an isopropyl group, an n-butyl group, an isobutyl group, a t-butyl group, and an n-pentyl group. The substituent may be an alkyl group having 1 to 3 carbon atoms, and may be a methyl group.

In the above formula (m-3), examples of the alkyl group having 1 to 5 carbon atoms represented by $R^{ha}$ are as described above. n represents, for example, an integer of 1 to 6, an integer of 1 to 3, or an integer of 4 to 6.

When the vinyl compound comprises at least one selected from the group consisting of a compound represented by formula (m-1) and a compound represented by formula (m-2), excellent heat resistance tends to be easily obtained. The vinyl compound may comprise a compound represented by formula (m-2) in which $L^2$ is a group represented by formula (m-2L). The vinyl compound may comprise a compound represented by formula (m-3) in which n is 4 to 8.

**In** some embodiments, the vinyl compound comprises a polymer having a maleimide group. In the present disclosure, a polymer having a maleimide group may be referred to as a "maleimide group-containing polymer". The vinyl compound may comprise a polymer having two maleimide groups; or may comprise a polymer having three or more maleimide groups. Examples of the maleimide compound comprise a polymer having a hydrocarbon-chain skeleton and having a maleimide group; a polymer having a phenolic resin-type skeleton and having a maleimide group; and a polyamide, polyamideimide, or polyimide having a maleimide group. Examples of the polymer having a hydrocarbon-chain skeleton and the phenolic resin are as listed for the vinyl phenyl group-containing polymer and the vinyl bond-containing polymer.

**In** some embodiments, the maleimide compound comprises a polymer represented by the following formula (M1).

[Chem. 22]

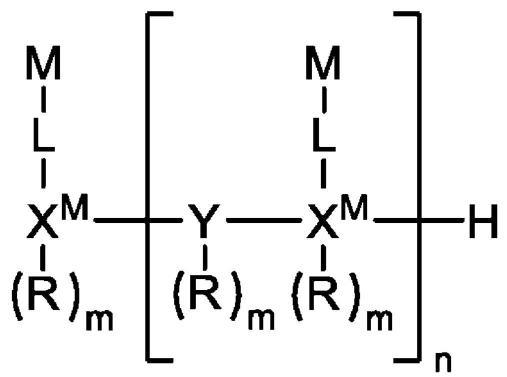

(M1)

(In the formula, each $X^M$ independently represents a benzene ring or a naphthalene ring, each Y independently represents an organic group, M represents a maleimide group, each L independently represents a direct bond or a linking group, each R independently represents a substituent, each m independently represents an integer of 0 to 5, and n represents a number of 2 to 10.)

The organic group may be a group comprises at least one carbon atom, and examples comprise an alkylene group such as a methylene group or an ethylene group; a cycloalkylene group such as tetrahydrodicyclopentadiene; an arylalkylene group such as a phenylmethylene group; and a divalent organic group containing an alkylene group and an arylene group.

Examples of the linking group comprise an alkylene group (the number of carbon atoms is, for example, 1 to 5), an oxy group, a thio group, a sulfonyl group, a sulfinyl group, a carbonyl group, a carbonyloxy group, an imino group, and a divalent group formed by bonding two or more selected from these.

Examples of the substituent represented by R comprise an alkyl group having 1 to 5 carbon atoms such as a methyl group, an ethyl group, an n-propyl group, an isopropyl group, an n-butyl group, an isobutyl group, a t-butyl group, and an n-pentyl group. The substituent may be an alkyl group having 1 to 3 carbon atoms, and may be a methyl group. Each m independently represents, for example, an integer of 0 to 4, an integer of 0 to 2, or 0.

n is an average value in the polymer represented by formula (M). n represents, for example, a number of 2 to 8, or a number of 3 to 5.

In some embodiments, the maleimide compound may comprise at least one selected from the group consisting of polymers represented by the following formulas. In the case where the vinyl compound comprises at least one selected from the group consisting of polymers represented by the following formulas, excellent heat resistance tends to be easily obtained.

[Chem. 23]

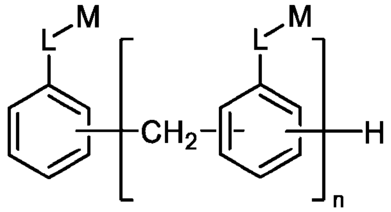

(M－1)

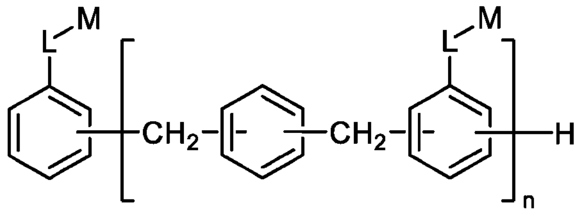

(M－2)

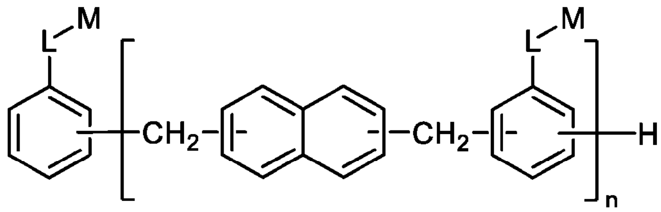

(M－3)

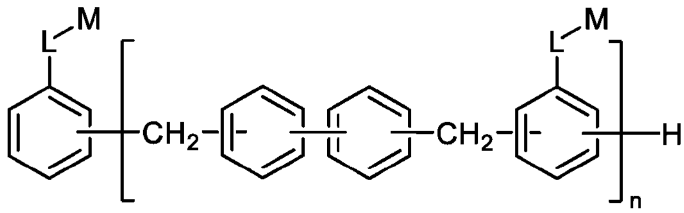

(M－4)

(In each formula, M represents a maleimide group, each L independently represents a direct bond or a linking group, and n represents a number of 2 to 10. Each of the benzene ring and the naphthalene ring may independently have a substituent at substitutable positions.)

When the benzene ring and the naphthalene ring in each formula have a substituent, examples of the substituent are as listed in formula (M1). The substituent may be an alkyl group having 1 to 3 carbon atoms, and may be a methyl group. Alternatively, the benzene ring and the naphthalene ring in each formula may be unsubstituted, or may have no substituent other than M-L-*.

n is an average value in the polymer represented by each formula. n represents, for example, a number of 2 to 8, or a number of 3 to 5.

Specific examples of the maleimide compound comprise: bis(4-maleimidophenyl)methane, polyphenylmethane maleimide, bis(4-maleimidophenyl)ether, bis(4-maleimidophenyl)sulfone, 3,3'-dimethyl-5,5'-diethyl-4,4'-diphenylmethane bismaleimide, 4-methyl-1,3-phenylene bismaleimide, m-phenylene bismaleimide, 2,2-bis(4-(4-maleimidophenoxy)phenyl)propane, 1,6'-bismaleimido-(2,2,4-trimethyl)hexane, 1,3-bis(3-maleimidophenoxy)benzene, 1,3-bis(4-maleimidophenoxy)benzene, Novolac-type maleimide compounds such as polyphenylmethane maleimide, and aralkyl-type maleimide compounds. The maleimide compound comprises, for example, at least one selected from the group consisting of 2,2-bis(4-(4-maleimidophenoxy)phenyl)propane, 1,6'-bismaleimido-(2,2,4-trimethyl)hexane, and polyphenylmethane maleimide.

A commercially available product may be used as the maleimide compound. Examples of the commercially available product comprise: "BMI-80" (2,2-bis[4-(4-maleimidophenoxy)phenyl]propane), "BMI-1000, BMI-1000H, BMI-1100, BMI-1100H" (all are 4,4'-diphenylmethane bismaleimide), "BMI-2000, BMI-2300" (all are phenylmethane maleimide), "BMI-3000, BMI-3000H" (all are m-phenylene bismaleimide), "BMI-4000" (bisphenol A diphenyl ether bismaleimide), "BMI-5100" (3,3'-dimethyl-5,5'-diethyl-4,4'-diphenylmethane bismaleimide), "BMI-7000, BMI-7000H" (all are 4-methyl-1,3-phenylene bismaleimide), and "BMI-TMH" (1,6'-bismaleimido-(2,2,4-trimethyl)hexane) manufactured by Daiwa Kasei Industry Co., Ltd.; "BMI-2500, BMI-2560, BMI-3000, BMI-5000, BMI-6100" manufactured by Designer Molecules Inc.; "NE-X470S" manufactured by DIC Corporation; and "MIR-3000-70MT" manufactured by Nippon

Kayaku Co., Ltd.

(Content)

When the sealing material comprises a vinyl compound, the sealing material may comprise only one type of vinyl compound or may comprise two or more types of vinyl compounds. When the sealing material comprises a vinyl compound, the content ratio of the vinyl compound is, for example, 10 to 90 mass%, 20 to 80 mass%, or 30 to 75 mass%, based on the mass of the sealing material (however, when the sealing material comprises a filler, the mass of the filler is excluded). When the content ratio is 10 mass% or more, there is a tendency that a sufficient effect by the vinyl compound is easily obtained. The content ratio of the vinyl compound may be 40 mass% or more, 50 mass% or more, 55 mass% or more, or 60 mass% or more. When the content ratio of the vinyl compound is 90 mass% or less, there is a tendency that the effect of improving heat resistance by the vinylphenyl compound is easily obtained.

When the sealing material comprises a vinyl compound, the content ratio of the vinyl compound is, for example, 10 to 90 mass%, 20 to 85 mass%, or 30 to 80 mass%, based on the total mass of the vinylphenyl compound and the vinyl compound. When the content ratio is 10 mass% or more, there is a tendency that a sufficient effect by the vinyl compound is easily obtained. The content ratio of the vinyl compound may be 40 mass% or more, 50 mass% or more, 60 mass%, or 70 mass% or more. When the content ratio of the vinyl compound is 90 mass% or less, there is a tendency that the effect of improving heat resistance by the vinylphenyl compound is easily obtained.

When the vinyl compound comprises a maleimide compound, the content ratio of the maleimide compound is, for example, 70 mass% or more, 80 mass% or more, or 90 mass% or more, based on the mass of the vinyl compound. The upper limit of the content ratio of the maleimide compound may be 100 mass%.

When the sealing material comprises a maleimide compound, the sealing material may comprise only one type of maleimide compound or may comprise two or more types of maleimide compounds. When the sealing material comprises a maleimide compound, the content ratio of the maleimide compound is, for example, 10 to 90 mass%, 20 to 80 mass%, or 30 to 75 mass%, based on the mass of the sealing material (however, when the sealing material comprises a filler, the mass of the filler is excluded). When the content ratio of the maleimide compound is 10 mass% or more, there is a tendency that the cured product exhibits a smaller amount of expansion. From the viewpoint of particularly reducing the amount of expansion, the content ratio of the maleimide compound may be 40 mass% or more, 50 mass% or more, 55 mass% or more, or 60 mass% or more. When the content ratio of the maleimide compound is 90 mass% or less, there is a tendency that the effect of improving heat resistance by the vinylphenyl compound is easily obtained.

When the sealing material comprises a maleimide compound, the content ratio of the maleimide compound is, for example, 10 to 90 mass%, 20 to 85 mass%, or 30 to 80 mass%, based on the total mass of the vinylphenyl compound and the maleimide compound. When the content ratio of the maleimide compound is 10 mass% or more, there is a tendency that the cured product exhibits a smaller amount of expansion. From the viewpoint of particularly reducing the amount of expansion, the content ratio of the maleimide compound may be 40 mass% or more, 50 mass% or more, 60 mass%, or 70 mass% or more. When the content ratio of the maleimide compound is 90 mass% or less, there is a tendency that the effect of improving heat resistance by the vinylphenyl compound is easily obtained.

When the sealing material comprises a maleimide compound, from the viewpoint of dielectric properties, curability, moldability, and conductor adhesion, the ratio of the content of vinyl phenyl groups to the content of maleimide groups in the sealing material (vinyl phenyl group (mol)/maleimide group (mol)) may be, for example, 0.05 to 5.0, 0.20 to 3.0, or 0.30 to 1.0.

[Optional components]

The sealing material may comprise optional components. Examples of optional components comprise various additives such as the above-described vinyl compounds, radical-polymerization initiators, fillers, coupling agents, releasing agents, colorants, polymerization inhibitors, ion exchangers, flame retardants, and stress relaxation agents. The sealing material can include various additives as needed, in addition to the examples described below.

(Radical-polymerization initiator)

The sealing material may comprise a radical-polymerization initiator. In the case where the sealing material is used for molding by heating, the radical-polymerization initiator may be a thermal radical-polymerization initiator that generates free radicals by heating. The thermal radical-polymerization initiator may be, for example, organic peroxides such as peroxyketals and dialkyl peroxides, or azo compounds such as azobisbutyronitrile and azobispropionitrile.

Examples of organic peroxides comprise: 1,1,3,3-tetramethylbutyl peroxyneodecanoate, di(4-t-butylcyclohexyl) peroxydicarbonate, di(2-ethylhexyl) peroxydicarbonate, cumyl peroxyneodecanoate, dilauroyl peroxide, 1-cyclohexyl-1-methylethyl peroxyneodecanoate, t-hexyl peroxyneodecanoate, t-butyl peroxyneodecanoate, t-butyl peroxypivalate,

1,1,3,3-tetramethylbutyl peroxy-2-ethylhexanoate, 2,5-dimethyl-2,5-di(2-ethylhexanoylperoxy)hexane, t-hexyl peroxy-2-ethylhexanoate, t-butyl peroxy-2-ethylhexanoate, t-butyl peroxyneoheptanoate, t-amyl peroxy-2-ethylhexanoate, di-t-butyl peroxyhexahydroterephthalate, t-amyl peroxy-3,5,5-trimethylhexanoate, 3-hydroxy-1,1-dimethylbutyl peroxyneodecanoate, t-amyl peroxyneodecanoate, di(3-methylbenzoyl) peroxide, dibenzoyl peroxide, di(4-methylbenzoyl) peroxide, t-hexyl peroxyisopropyl monocarbonate, t-butyl peroxymaleic acid, t-butyl peroxy-3,5,5-trimethylhexanoate, t-butyl peroxylaurate, 2,5-dimethyl-2,5-di(3-methylbenzoylperoxy)hexane, t-butyl peroxy-2-ethylhexyl monocarbonate, t-hexyl peroxybenzoate, 2,5-dimethyl-2,5-di(benzoylperoxy)hexane, t-butyl peroxybenzoate, dibutyl peroxytrimethyl adipate, t-amyl peroxynormal octoate, t-amyl peroxyisononanoate, and t-amyl peroxybenzoate.

Examples of azo compounds comprise: 2,2'-azobis-2,4-dimethylvaleronitrile, 1,1'-azobis(1-acetoxy-1-phenylethane), 2,2'-azobisisobutyronitrile, 2,2'-azobis(2-methylbutyronitrile), 4,4'-azobis(4-cyanovaleric acid), and 1,1'-azobis(1-cyclohexanecarbonitrile).

When the sealing material comprises a radical-polymerization initiator, the sealing material may comprise only one type of radical-polymerization initiator, or may comprise two or more types of radical-polymerization initiators. When the sealing material comprises a radical-polymerization initiator, the content ratio of the radical-polymerization initiator may be 0.1 to 5 mass%, or 0.2 to 3 mass%, based on the total mass of the vinylphenyl compound and the vinyl compound included as necessary (in the case where the sealing material does not comprise a vinyl compound, the mass of the vinylphenyl compound; the same applies hereinafter). For example, in the case where the sealing material does not comprise a vinyl compound, the sealing material may comprise a radical-polymerization initiator.

(Filler)

The sealing material may comprise a filler. When the sealing material comprises a filler, properties of the cured product such as thermal expansion coefficient, thermal conductivity, and elastic modulus tend to be improved. Examples of the filler comprise inorganic fillers and organic fillers. In some embodiments, the sealing material comprises an inorganic filler.

The average particle diameter of the inorganic filler may be 5 μm or more. The average particle diameter of the inorganic filler may be 100 μm or less from the viewpoint of improving the filling property of the sealing material. The average particle diameter of the inorganic filler is, for example, 5 to 100 μm, 8 to 50 μm, or 10 to 30 μm.

The average particle diameter of the inorganic filler can be obtained by the following method. A thin section sample is prepared from the sealing material or the cured product of the sealing material. In an image of the thin section sample captured by a scanning electron microscope, 100 particles of the inorganic filler are randomly selected. The major diameter of each particle is measured, and the value obtained by arithmetic averaging is defined as the average particle diameter of the inorganic filler.

The type of the inorganic filler is not particularly limited. Examples thereof comprise silica such as fused silica and crystalline silica; and inorganic fillers such as alumina, zirconia, titania, glass, talc, clay, and mica. The inorganic filler may be an inorganic filler having a flame retardant effect. Examples of the inorganic filler having a flame retardant effect comprise: aluminum hydroxide; magnesium hydroxide; composite metal hydroxides such as a composite hydroxide of magnesium and zinc; and zinc borate.

The inorganic filler may comprise silica from the viewpoint of reducing the linear expansion coefficient. The inorganic filler may comprise alumina from the viewpoint of high thermal conductivity. Examples of the form of the inorganic filler comprise: powder, beads formed by shaping powder into a spherical shape, and fibers.

In the case where the sealing material comprises a filler, the sealing material may comprise only one type of filler, or may comprise two or more types of fillers. In the case where the sealing material comprises a filler, the content ratio of the filler is, for example, 100 to 2000 mass%, 250 to 1500 mass%, or 350 to 700 mass%, based on the mass of the sealing material (excluding the mass of the filler). When the content ratio of the filler is 100 mass% or more, properties such as the thermal expansion coefficient, thermal conductivity, and elastic modulus of the cured product tend to be further improved. When the content ratio of the filler is 2000 mass% or less, an increase in the viscosity of the sealing material is suppressed, and the fluidity tends to be further improved, resulting in better moldability. In the case where the sealing material comprises a filler, the content ratio of the filler (excluding carbon black) is, for example, 50 to 90 volume%, 55 to 85 volume%, or 60 to 80 volume%, based on the volume of the sealing material. When the content ratio of the filler is 50 volume% or more, properties such as the thermal expansion coefficient, thermal conductivity, and elastic modulus of the cured product tend to be further improved. When the content ratio of the filler is 90 volume% or less, an increase in the viscosity of the sealing material is suppressed, and the fluidity tends to be further improved, resulting in better moldability.

(Coupling agent)

The sealing material may comprise a coupling agent. In the case where the sealing material comprises a coupling agent, the adhesiveness of the cured product, or the adhesiveness between the resin component (vinylphenyl compound,

vinyl compound included as necessary, etc.) and the inorganic filler tends to be improved. Examples of the coupling agent comprise: silane coupling agents, titanate coupling agents, aluminum chelate-based coupling agents, and aluminum/-zirconium-based coupling agents. The silane coupling agent may be, for example, an epoxy-based silane coupling agent, a mercapto-based silane coupling agent, an amino-based silane coupling agent, an alkyl-based silane coupling agent, a ureido-based silane coupling agent, a vinyl-based silane coupling agent, a (meth)acrylic-based silane coupling agent, or a disilazane-based coupling agent. In the present disclosure, in the case where the sealing material comprises a coupling agent, a coupling agent having a vinyl phenyl group is excluded from the scope of the above-described vinylphenyl compound, and a coupling agent having a vinyl group is excluded from the scope of the above-described vinyl compound. That is, the vinylphenyl compound and the vinyl compound are compounds other than compounds corresponding to coupling agents. In the case where the sealing material comprises a mercapto-based silane coupling agent or an amino-based silane coupling agent, the adhesiveness of the cured product tends to be improved. In the case where the sealing material comprises a vinyl-based silane coupling agent or a (meth)acrylic-based silane coupling agent, the moldability and the strength of the cured product tend to be improved.

Examples of the silane coupling agent comprise: vinyltrichlorosilane, vinyltriethoxysilane, vinyltris(β-methoxyethoxy)silane, γ-methacryloxypropyltrimethoxysilane, β-(3,4-epoxycyclohexyl)ethyltrimethoxysilane, γ-glycidoxypropyltrimethoxysilane, γ-glycidoxypropylmethyldimethoxysilane, vinyltriacetoxysilane, γ-mercaptopropyltrimethoxysilane, γ-aminopropyltrimethoxysilane, N-phenyl-3-aminopropyltrimethoxysilane, γ-aminopropylmethyldimethoxysilane, γ-aminopropyltriethoxysilane, γ-aminopropylmethyldiethoxysilane, γ-anilinopropyltrimethoxysilane, γ-anilinopropyltriethoxysilane, γ-(N,N-dimethyl)aminopropyltrimethoxysilane, γ-(N,N-diethyl)aminopropyltrimethoxysilane, γ-(N,N-dibutyl)aminopropyltrimethoxysilane, γ-(N-methyl)anilinopropyltrimethoxysilane, γ-(N-ethyl)anilinopropyltrimethoxysilane, γ-(N,N-dimethyl)aminopropyltriethoxysilane, γ-(N,N-diethyl)aminopropyltriethoxysilane, γ-(N,N-dibutyl)aminopropyltriethoxysilane, γ-(N-methyl)anilinopropyltriethoxysilane, γ-(N-ethyl)anilinopropyltriethoxysilane, γ-(N,N-dimethyl)aminopropylmethyldimethoxysilane, γ-(N,N-diethyl)aminopropylmethyldimethoxysilane, γ-(N,N-dibutyl)aminopropylmethyldimethoxysilane, γ-(N-methyl)anilinopropylmethyldimethoxysilane, γ-(N-ethyl)anilinopropylmethyldimethoxysilane, N-(trimethoxysilylpropyl)ethylenediamine, N-(dimethoxymethylsilylisopropyl)ethylenediamine, methyltrimethoxysilane, dimethyldimethoxysilane, methyltriethoxysilane, γ-chloropropyltrimethoxysilane, hexamethyldisilane, vinyltrimethoxysilane, γ-mercaptopropylmethyldimethoxysilane, and the like.

When the sealing material comprises a coupling agent, the sealing material may comprise only one type of coupling agent or may comprise two or more types of coupling agents. In the case where the sealing material comprises an inorganic filler and a coupling agent, the content ratio of the coupling agent is, for example, 0.01 to 10 mass%, 0.05 to 5 mass%, or 0.1 to 2 mass%, based on the mass of the inorganic filler. In the case where the content ratio of the coupling agent is 0.1 mass% or more, the adhesiveness of the cured product tends to be improved. In the case where the content ratio of the coupling agent is 2 mass% or less, the moldability of the cured product tends to be improved.

(Releasing agent)

The sealing material may comprise a releasing agent. In the case where the sealing material comprises a releasing agent, good releasability from a mold during molding is easily obtained. Examples of the releasing agent comprise: carnauba wax; higher fatty acids such as montanic acid and stearic acid, and higher fatty acid metal salts; ester-based waxes such as montanic acid ester; and polyolefin-based waxes such as oxidized polyethylene and non-oxidized polyethylene.

In the case where the sealing material comprises a releasing agent, the sealing material may comprise only one type of releasing agent or may comprise two or more types of releasing agents. In the case where the sealing material comprises a releasing agent, the content ratio of the releasing agent is, for example, 0.01 to 10 mass%, 0.05 to 5 mass%, or 0.1 to 2 mass%, based on the total mass of the vinylphenyl compound and the vinyl compound included as needed. In the case where the content ratio of the releasing agent is 0.01 mass% or more, sufficient releasability tends to be obtained. In the case where the content ratio of the releasing agent is 10 mass% or less, better adhesiveness tends to be obtained.

(Colorant)

The sealing material may comprise a colorant. Examples of the colorant comprise: carbon black, organic dyes, organic pigments, titanium oxide, red lead, red iron oxide, and the like. The content of the colorant can be appropriately selected according to the purpose and the like. The colorant may be a colorant that also functions as a filler.

In the case where the sealing material comprises a colorant, the sealing material may comprise only one type of colorant or may comprise two or more types of colorants. In the case where the sealing material comprises a colorant, the content ratio of the colorant is, for example, 0.01 to 10 mass%, or 0.1 to 5 mass%, based on the total mass of the vinylphenyl compound and the vinyl compound included as needed.

(Polymerization inhibitor)

The sealing material may comprise a polymerization inhibitor. Examples of the polymerization inhibitor comprise: phenolic compounds such as hydroquinone, methylhydroquinone, hydroquinone monomethyl ether, catechol, and pyrogallol; and hindered amine compounds.

(Ion exchanger)

The sealing material may comprise an ion exchanger. In the case where the sealing material comprises an ion exchanger, the moisture resistance and high-temperature storage characteristics of the electronic component device tend to be improved. Examples of the ion exchanger comprise: hydrotalcite compounds; and hydrous oxides of at least one element selected from the group consisting of magnesium, aluminum, titanium, zirconium, and bismuth. The ion exchanger may be an ion exchanger that also functions as a filler. The sealing material may comprise only one type of ion exchanger or may comprise two or more types of ion exchangers.

(Flame retardant)

The sealing material may comprise a flame retardant. Examples of the flame retardant comprise organic or inorganic compounds comprises a halogen atom, an antimony atom, a nitrogen atom, or a phosphorus atom, and metal hydroxides. The sealing material may comprise only one type of flame retardant or may comprise two or more types of flame retardants.

(Stress relaxation agent)

The sealing material may comprise a stress relaxation agent. In the case where the sealing material comprises a stress relaxation agent, warpage deformation and occurrence of cracks in the electronic component device tend to be reduced. Examples of the stress relaxation agent comprise: silicone oil; thermoplastic elastomers such as silicone-based, styrene-based, olefin-based, urethane-based, polyester-based, polyether-based, polyamide-based, and polybutadiene-based elastomers; rubber particles such as NR (natural rubber), NBR (acrylonitrile-butadiene rubber), acrylic rubber, urethane rubber, and silicone powder; and rubber particles having a core-shell structure such as methyl methacrylate-styrene-butadiene copolymer (MBS), methyl methacrylate-silicone copolymer, and methyl methacrylate-butyl acrylate copolymer (excluding compounds corresponding to vinylphenyl compounds or vinyl compounds). In the case where the sealing material comprises a stress relaxation agent, the sealing material may comprise only one type of stress relaxation agent or may comprise two or more types of stress relaxation agents. As the stress relaxation agent, commercially available flexibility-imparting agents can be used.

[5% weight loss temperature (Td5) of cured product]

In some embodiments, the sealing material has a 5% weight loss temperature (Td5) of the cured product measured by thermogravimetry-differential thermal analysis (TG-DTA) of, for example, 400°C or higher, 420°C or higher, 430°C or higher, or 450°C or higher. The larger the Td5, the better the heat resistance the electronic component device tends to exhibit.

In the present disclosure, Td5 (°C) is measured by heating the cured product under conditions of a measurement temperature range of 40 to 600°C and a heating rate of 10°C/min. The cured product for measurement may be a cured product prepared by transfer molding using the sealing material. The molding conditions are a molding temperature of 175°C, a molding time of 120 seconds, and a molding pressure of 6.9 MPa, the curing conditions are a heating temperature of 175°C and a heating time of 6 hours, and the size of the cured product is 4 mm × 4 mm × 20 mm. For the measurement, a thermogravimetric differential thermal analyzer (for example, "TG-DTA STA-7200" manufactured by Hitachi High-Tech Corporation) can be used.

Since the vinylphenyl compound has good curability, in the case where the sealing material comprises the vinylphenyl compound, a cured product with high crosslinking density can be obtained. Since the vinylphenyl compound contains an aromatic ring in the skeleton, a rigid cured product can be obtained. In addition, the vinylphenyl compound does not contain a structure represented by formulas (X1) or (X2) in the skeleton. As a result of these, Td5 can be increased. Furthermore, when the content ratio of aromatic rings in the skeleton of the resin component (vinylphenyl compound, vinyl compound, etc.) is high; or when the crosslinking density of the cured product is higher, the Td5 of the cured product tends to increase.

[Amount of expansion of cured product]

In some embodiments, the sealing material has an amount of expansion of the cured product measured by thermomechanical analysis (TMA) of, for example, 120 μm or less, 110 μm or less, 100 μm or less, or 90 μm or less. The smaller the amount of expansion, the more the warpage of the electronic component device tends to be suppressed. The lower limit of the amount of expansion is not particularly limited, but the amount of expansion is, for example, 30 μm or more.

In the present disclosure, the amount of expansion (μm) can be obtained using the displacement amount (μm) measured by applying a compressive load to the cured product under conditions of a load of 0.1 N, a measurement temperature range of 30 to 260°C, and a heating rate of 10°C/min. The cured product for measurement may be a cured product prepared by transfer molding using the sealing material. The molding conditions are a molding temperature of 175°C, a molding time of 120 seconds, and a molding pressure of 6.9 MPa, the curing conditions are a heating temperature of 175°C and a heating time of 6 hours, and the size of the cured product is 4 mm × 4 mm × 20 mm. A thermomechanical analyzer (for example, "TMA450" manufactured by TA Instruments) can be used for the measurement. The amount of expansion (μm) can be obtained from the displacement amount (μm) at 30°C and the displacement amount (μm) at 260°C by the following formula.

Amount of expansion (μm) = Displacement amount (μm) at 260°C - Displacement amount (μm) at 30°C

Since the vinylphenyl compound has good curability, when the sealing material comprises the vinylphenyl compound, a cured product with high crosslinking density can be obtained. Since the vinylphenyl compound contains an aromatic ring in the skeleton, a rigid cured product can be obtained. In addition, the vinylphenyl compound does not contain a structure represented by formulas (X1) or (X2) in the skeleton. As a result of these, the amount of expansion can be suppressed to be small. Furthermore, when the content ratio of aromatic rings in the skeleton of the resin component (vinylphenyl compound, vinyl compound, etc.) is high; the crosslink density of the resin component is higher; silica having a small coefficient of linear expansion is contained as a filler; or the volume fraction of the filler is large, the amount of expansion of the cured product tends to be small.

[Molding Shrinkage Rate of Cured Product]

In some embodiments, the sealing material has a molding shrinkage rate of the cured product of, for example, 0.30% or less, 0.28% or less, 0.26% or less, or 0.24% or less. The smaller the shrinkage rate, the more the warpage of the electronic component device tends to be suppressed.

In the present disclosure, the molding shrinkage rate (%) is measured by preparing a disk-shaped cured product by transfer molding and using the size of the cured product and the size of the mold used for transfer molding. The molding conditions are a molding temperature of 175°C, a molding time of 120 seconds, and a molding pressure of 6.9 MPa, and the curing conditions are a heating temperature of 175°C and a heating time of 6 hours. The size of the disk-shaped cured product used for measurement is, for example, a diameter of about 80 mm × a thickness of about 4 mm. The molding shrinkage rate (%) can be obtained from the average value Rm (mm) of the diameters of the front side and the back side of the cured product, and the average value Rd (mm) of the inner diameter of the mold corresponding to the front of the cured product and the inner diameter of the mold corresponding to the back of the cured product, by the following formula.

$$\text{Molding shrinkage rate (\%)} = (Rd - Rm) / Rd \times 100$$

In the case of a high content ratio of aromatic rings included in the skeleton of the resin component (vinylphenyl compound, vinyl compound, etc.) forming the cured product and the resin component being rigid, the molding shrinkage rate tends to be small.

[Water absorption rate of cured product]

In some embodiments, the sealing material has a water absorption rate of the cured product of, for example, 0.60% or less, 0.50% or less, 0.40% or less, or 0.30% or less. The smaller the water absorption rate, the more the reliability of the electronic component device tends to improve.

In the present disclosure, the water absorption rate (%) is measured by preparing a disk-shaped cured product by transfer molding, subjecting the cured product to pressure cooker treatment, and using the mass of the cured product before and after the treatment. The molding conditions are a molding temperature of 175°C, a molding time of 120 seconds, and a molding pressure of 6.9 MPa, and the curing conditions are a heating temperature of 175°C and a heating

time of 6 hours. The size of the disk-shaped cured product used for measurement is, for example, a diameter of 50 mm × a thickness of 3 mm. The conditions for the pressure cooker treatment are a pressure of 2 atm (0.2 MPa), a temperature of 121°C, a relative humidity of 100% RH, and a time of 20 hours. The water absorption rate (mass%) can be obtained by measuring the mass of the cured product before and after the pressure cooker treatment and using the following formula.

Water absorption rate (mass%) = ((mass after treatment - mass before treatment) / mass before treatment) × 100

In the polymerization reaction of the vinylphenyl compound and the vinyl compound included as necessary, unlike in the reaction between an epoxy resin and a phenolic resin, hydroxyl groups are not formed. Therefore, the water absorption rate of the cured product can be suppressed to a low level.

[Method for producing sealing material]

The method for producing the sealing material is not particularly limited. For example, a method can be listed in which components in predetermined blending amounts are sufficiently mixed by a mixer or the like, then melt-kneaded, cooled, and pulverized. For melt-kneading, a kneader such as a twin-screw kneader; a roll such as a mixing roll; an extruder such as an extruder can be used. The temperature of melt-kneading is, for example, 70 to 140°C, or 80 to 130°C. The sealing material may be solid under normal temperature and normal pressure (for example, 25°C, atmospheric pressure). The shape of the solid sealing material is not particularly limited, and examples comprise powder, granular, and tablet forms.

<Sealing member>

In some embodiments, the sealing member comprises a cured product obtained using the sealing material of the above embodiment. The sealing member can be used for sealing electronic components, electronic component devices, semiconductor elements, semiconductor devices, and the like. The cured product can be produced, for example, by molding the sealing material and heating the obtained molded product. The heating conditions are, for example, 150 to 180°C for 2 to 16 hours.

<Electronic component device>

In some embodiments, the electronic component device has the sealing member of the above embodiment. The electronic component device has, for example, an electronic component and the sealing member of the above embodiment that seals at least a part of the electronic component. The electronic component device may be, for example, an electronic component module having a plurality of members selected from the group consisting of electronic components and electronic component devices, and the sealing member of the above embodiment that seals at least a part of the plurality of members.

Examples of electronic components comprise active elements or active components such as diodes, transistors, integrated circuits, and relays; passive elements or components such as resistors, capacitors, and coils; connectors, support members, terminals, switches, and the like. Examples of electronic component devices comprise electronic component devices provided with the electronic components; modules having one or both of the electronic components and the electronic component devices, and the like. The electronic component device may have a support member. Examples of support members comprise: lead frames, wired tape carriers, wiring boards, glass, silicon wafers, organic substrates, and the like.

The semiconductor device has, for example, a semiconductor element and the sealing member of the above embodiment that seals at least a part of the semiconductor element. The semiconductor device may be, for example, a semiconductor module having a plurality of members selected from the group consisting of semiconductor elements and semiconductor devices, and the sealing member of the above embodiment that seals at least a part of the plurality of members.

Examples of semiconductor elements comprise: diodes, transistors, thyristors, power semiconductor elements, photoelectric conversion elements, sensors, ICs (integrated circuits), memories, and the like. The semiconductor device may be in the form of a known package, and examples comprise through-hole mount type packages and surface-mount-type-packages. Examples of surface-mount-type-packages comprise: lead-frame-type packages, bump-type packages, and the like. Specific examples comprise: resin-sealed ICs (Integrated Circuits) such as SIP (Single Inline Package), DIP (Dual Inline Package), PGA (Pin Grid Array), PLCC (Plastic Leaded Chip Carrier), QFP (Quad Flat Package), SOP (Small Outline Package), SOJ (Small Outline J-lead package), TSOP (Thin Small Outline Package), and TQFP (Thin Quad Flat Package); TCP (Tape Carrier Package); COB (Chip On Board); BGA (Ball Grid Array); CSP (Chip Size Package), and the

like. Furthermore, specific examples comprise: MCP (Multi Chip Package) such as MCM (Multi-Chip Module); hybrid ICs, and the like.

Resin-sealed ICs have, for example, a structure in which a semiconductor element is fixed on a lead frame, terminal portions of the semiconductor element such as bonding pads and lead portions are connected by wire bonding, bumps, or the like, and then sealed by transfer molding or the like using a sealing material. TCPs have, for example, a structure in which a semiconductor element connected to a tape carrier by bumps is sealed with a sealing material. COBs have, for example, a structure in which a semiconductor element connected to wiring formed on a support member by wire bonding, flip chip bonding, solder, or the like is sealed with a sealing material. BGAs, CSPs, and MCPs have, for example, a structure in which a semiconductor element is mounted on the surface of a support member having terminals for wiring board connection formed on the back surface, the semiconductor element and wiring formed on the support member are connected by bumps or wire bonding, and then the semiconductor element is sealed with a sealing material. MCMs have, for example, a structure in which multiple semiconductor elements connected to wiring formed on a support member by wire bonding, flip chip bonding, solder, or the like are sealed with a sealing material.

For example, a method for manufacturing an electronic component device comprises placing an electronic component on a support member, and sealing at least a part of the electronic component using the sealing material of the above embodiment. For example, methods for sealing an electronic component or an electronic component device comprise transfer molding, compression molding, injection molding, and the like. Transfer molding can be performed, for example, under conditions of a molding temperature of 130 to 180°C, a molding pressure of 6 to 10 MPa, and a molding time of 60 to 120 seconds. Heating conditions in post-curing are, for example, 150 to 180°C for 2 to 16 hours.

Examples of embodiments are listed below. The present invention is not limited to the following embodiments.

(1) A sealing material comprising a structural unit represented by the following formula (Bb1).
(2) The sealing material according to (1) above, wherein the compound having the structural unit represented by the formula (Bb1) comprises a compound represented by the following formula (b2).
(3) The sealing material according to (1) or (2) above, wherein the compound having the structural unit represented by the formula (Bb1) comprises a polymer represented by the following formula (B4).
(4) The sealing material according to any one of (1) to (3) above, comprising a compound having a vinyl group.
(5) The sealing material according to claim 4, wherein the compound having a vinyl group includes a compound having a maleimide group.
(6) The sealing material according to any one of (1) to (5) above, wherein the sealing material is a radically polymerizable sealing material.
(7) A sealing member comprising a cured product obtained by using the sealing material according to any one of (1) to (6) above.
(8) An electronic component device comprising the sealing member according to (7) above.
(9) A semiconductor device comprising a semiconductor element and the sealing member according to (7) above, wherein the sealing member seals at least a part of the semiconductor element.
(10) A semiconductor module having a plurality of members selected from the group consisting of semiconductor elements and semiconductor devices, and the sealing member according to (7) above, wherein the sealing member seals at least a part of the plurality of members.

The disclosure of the present application is related to the subject matter described in Japanese Patent Application No. 2023-128624 filed on August 7, 2023, and the entire disclosure content thereof is incorporated herein by reference.

## Examples

Embodiments of the present disclosure are specifically described by Examples. The embodiments of the present disclosure are not limited to the following Examples.

### <Synthesis of Vinylphenyl Compound>

(Synthesis Example 1: Synthesis of Vinylphenyl Compound 1)

A phenolic resin, chloromethylstyrene, a phase transfer catalyst, pure water, a polymerization inhibitor, and a solvent described in Table 1 were added to a reaction vessel having a volume of 500 mL equipped with a stirring device, a thermometer, a reflux tube, and an air pump. The obtained composition was stirred at a temperature of 40°C while blowing air at a flow rate of 50 mL/min. Next, while maintaining the temperature at 70°C, the basic compound described in Table 1 was added dropwise over a period of 20 minutes, and the mixture was further stirred at 70°C for 4 hours. Blowing of air was

continued during the reaction. The composition was cooled to room temperature (25°C), neutralized with a 10 mass% hydrochloric acid aqueous solution, and then the organic phase was washed three times with pure water. Thereafter, the organic phase was precipitated in methanol to obtain the target vinylphenyl compound 1. Vinylphenyl compound 1 was confirmed by infrared absorption (IR) spectrum analysis to have a structure in which substantially all of the phenolic hydroxyl groups of the phenolic resin were replaced with vinyl benzyl ether groups (vinylphenylmethyloxy groups). The weight average molecular weight of vinylphenyl compound 1 is shown in Table 1.

(Synthesis Example 2: Synthesis of Vinylphenyl Compound 2)

Vinylphenyl compound 2 was obtained in the same manner as in Synthesis Example 1 except that the raw materials were changed to those described in Table 1. By infrared absorption (IR) spectrum analysis, it was confirmed that vinylphenyl compound 2 has a structure in which substantially all of the phenolic hydroxyl groups of the phenolic resin were replaced with vinyl benzyl ether groups. The weight average molecular weight of vinylphenyl compound 2 is shown in Table 1.

(Synthesis Example 3: Synthesis of Vinylphenyl Compound 3)

To a reaction vessel having a volume of 500 mL equipped with a stirring device, a thermometer, a reflux tube, and a nitrogen inlet, the aromatic hydrocarbon, chloromethylstyrene, phase transfer catalyst, polymerization inhibitor, and solvent described in Table 1 were added. The obtained composition was stirred at a temperature of 40°C while blowing nitrogen at a flow rate of 50 mL/min. Next, the basic compound described in Table 1 was added dropwise over a period of 20 minutes, and the mixture was further stirred at 60°C for 9 hours. Nitrogen blowing was continued during the reaction. The composition was cooled to room temperature (25°C), neutralized with a 10 mass% hydrochloric acid aqueous solution, and then washed twice with pure water. Thereafter, toluene was distilled off under reduced pressure, and the obtained viscous liquid was washed with methanol and then vacuum dried to obtain vinylphenyl compound 3. By $^{1}$H-nuclear magnetic resonance ($^{1}$H-NMR) analysis, it was confirmed that vinylphenyl compound 3 has a structure in which substantially all of the two hydrogen atoms directly bonded to the carbon atom at the 1-position of indene were substituted with vinyl benzyl groups (vinylphenylmethyl groups). In addition, by the analysis using the GPC method, it was confirmed that vinylphenyl compound 3 is a mixture of a compound having two vinyl benzyl groups introduced and a compound having three vinyl benzyl groups introduced, and the average number of vinyl benzyl groups is within the range of 1.6 to 2.6. The weight average molecular weight of vinylphenyl compound 3 is shown in Table 1.

In the Examples, the weight average molecular weight (Mw) and number average molecular weight (Mn) were measured under the following conditions.

The weight average molecular weight (Mw) and number average molecular weight (Mn) were converted from a calibration curve using standard polystyrene by gel permeation chromatography (GPC). The calibration curve was approximated by a cubic equation using standard polystyrene: TSKstandard POLYSTYRENE (Type; A-2500, A-5000, F-20, F-80) (Tosoh Corporation).

Apparatus: High-speed GPC apparatus HLC-8320GPC (Tosoh Corporation)
Detector: Ultraviolet absorption detector UV-8320 (Tosoh Corporation)
Column: Guard column; TSKgel guardcolumn Super(HZ)-M + Column; TSKgel SuperMultipore HZ-M (2 columns), Reference column; TSKgel SuperH-RC (2 columns) (all from Tosoh Corporation)
Column size: 4.6 × 20 mm (guard column), 4.6 × 150 mm (column), 6.0 × 150 mm (reference column)
Eluent: tetrahydrofuran
Sample concentration: 10 mg/l mL
Injection volume: 20 μL or 2 μL
Flow rate: 0.35 mL/min
Measurement temperature: 40°C

The compounds described in Table 1 are as follows. In Table 1, the unit of each compound is "parts by mass". "-" means that the corresponding compound was not used. The hydroxyl group equivalent of the phenolic resin was measured by the method described above.

(Phenolic resin)

- HE100C-30: aralkyl-type phenolic resin, Air Water Inc., weight average molecular weight (Mw) 2350, number

average molecular weight (Mn) 450, hydroxyl group equivalent 170 to 175 g/eq

- MEHC-7851M: biphenyl aralkyl-type phenolic resin, Meiwa Kasei Co., Ltd., weight average molecular weight (Mw) 1500, number average molecular weight (Mn) 900, hydroxyl group equivalent 201 to 220 g/eq

(Aromatic hydrocarbon)

- Indene: molecular weight 116.2

[Chem. 24]

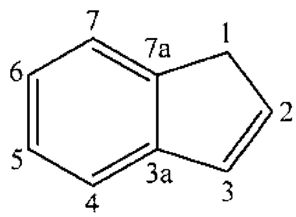

(Chloromethylstyrene)

- CMS: mixture of o-chloromethylstyrene and p-chloromethylstyrene, Wujin Linchuan Chemical Co., o-chloromethylstyrene content ratio of 17 mass%, p-chloromethylstyrene content ratio of 83 mass%
- CMS-P: mixture of m-chloromethylstyrene and p-chloromethylstyrene, AGC Seimi Chemical Co., Ltd., m-chloromethylstyrene content ratio of 50 mass%, p-chloromethylstyrene content ratio of 50 mass%

(Phase transfer catalyst)

- Tetrabutylphosphonium bromide: Kanto Chemical Co., Inc.
- Tetra-n-butylammonium bromide: Kanto Chemical Co., Inc.

(Polymerization inhibitor)

- Phenothiazine

(Organic solvent)

- Toluene

- 2-Propanol

(Basic compound)

Sodium hydroxide aqueous solution: Kanto Chemical Co., Inc., concentration 48 mass%

[Table 1]

Table 1

| | | Synthesis Example | | |
|---|---|---|---|---|
| | | 1 | 2 | 3 |
| Phenolic resin/ Aromatic hydrocarbon | HE100C-30 | 87.0 | - | - |
| | MEHC-7851M | - | 89.6 | - |
| | Indene | - | - | 35.6 |
| Chloromethylstyrene | CMS | 84.3 | - | 99.1 |
| | CMS-P | - | 75.9 | - |
| Phase transfer catalyst | Tetrabutylphosphonium bromide | 17.7 | 15.3 | - |
| | Tetra-n-butylammonium bromide | - | - | 7.1 |
| Pure water | - | 5.9 | 5.1 | - |
| Polymerization inhibitor | Phenothiazine | 0.2 | 0.2 | 0.1 |
| Organic solvent | Toluene | 108.8 | 111.9 | 76.4 |
| | 2-Propanol | 21.8 | 22.4 | - |
| Basic compound | Sodium hydroxide aqueous solution | 62.5 | 46.5 | 46.5 |
| Weight average molecular weight (Mw) of vinylphenyl compound | | 4200 | 2000 | 500 |

<Preparation of sealing material (composition for sealing member)>

Each of the vinylphenyl compounds obtained in Synthesis Examples 1 to 3 were placed in a metal tray and left in a vacuum dryer at a pressure of 0.1 MPa or less and a temperature of 70°C for 5 hours to remove the solvent.

[Examples 1 to 9 and Comparative Example 1]

The vinylphenyl compound after removing the solvent, and the compounds described in Table 2 were premixed (dry blended), then kneaded with a twin-screw kneader (kneading temperature 120°C), and the kneaded product was cooled and pulverized to produce a powdered composition for sealing member.

The compounds described in Table 2 are as follows. In Table 2, the unit of each compound is "parts by mass". "-" represents that the corresponding compound is not included. The average particle diameter of the inorganic filler was measured by the method described above. The content ratio (volume%) of the inorganic filler is the ratio of the volume of silica based on the volume of the composition for sealing member. "Vinyl phenyl group equivalent/maleimide group equivalent" is the ratio of the vinyl phenyl group equivalent (weight average molecular weight/number of functional groups) of the vinylphenyl compound to the maleimide group equivalent (molecular weight calculated from chemical formula/-number of functional groups) of the maleimide compound.

(Vinylphenyl compound)

- Vinylphenyl compound 1: Vinylphenyl compound (vinylbenzylether compound) obtained in Synthesis Example 1
- Vinylphenyl compound 2: Vinylphenyl compound (vinylbenzylether compound) obtained in Synthesis Example 2
- Vinylphenyl compound 3: Vinylphenyl compound (vinylbenzyl compound) obtained in Synthesis Example 3

(Vinyl compound)

- Maleimide compound 1: 2,2-bis[4-(4-maleimidophenoxy)phenyl]propane, K.I Chemical Industry Co., Ltd. "BMI-80"
- Maleimide compound 2: Polyphenylmethane maleimide, Daiwa Kasei Industry Co., Ltd. "BMI-2300"
- Maleimide compound 3: 1,6'-bismaleimido-(2,2,4-trimethyl)hexane, Daiwa Kasei Industry Co., Ltd. "BMI-TMH"

(Epoxy compound)

- Epoxy resin 1: Triphenylmethane-type epoxy resin, Nippon Kayaku Co., Ltd. "EPPN-501HY"
- Epoxy resin 2: Biphenyl-type epoxy resin, Mitsubishi Chemical Corporation "YX4000H"

(Phenolic resin)

- Phenolic resin: Biphenyl aralkyl resin, UBE Corporation "MEHC7851-SS"

(Other raw materials)

- Radical-polymerization initiator: α,α'-Di(t-butylperoxy)diisopropylbenzene, NOF Corporation "PERBUTYL P"
- Curing accelerator: Phosphorus-based accelerator
- Coupling agent 1: 3-mercaptopropyltrimethoxysilane, Shin-Etsu Chemical Co., Ltd. "KBM-803"
- Coupling agent 2: N-phenyl-3-aminopropyltrimethoxysilane, Shin-Etsu Chemical Co., Ltd. "KBM-573"
- Releasing agent: Montanic acid ester wax, Clariant Japan K.K. "HW-E"
- Colorant: Carbon black, Mitsubishi Chemical Corporation " MA100RMJ "
- Inorganic filler: Silica (average particle diameter 26.9 μm), Zhejiang Huafei Electronic Basic Material Co., Ltd. "SS-205"

<Preparation of Cured Product>

A cured product was prepared using the composition for sealing member, and the 5% weight loss temperature, amount of expansion, molding shrinkage rate, and water absorption rate were measured. The measurement results are shown in Table 2.

(Measurement of 5% Weight Loss Temperature (Td5))

A molded product of 4 mm × 4 mm × 20 mm was obtained using a transfer molding machine (Techno Maluchi Co., Ltd.) under conditions of a molding temperature of 175°C, a molding time of 120 seconds, and a molding pressure of 6.9 MPa. The obtained molded product was heated and cured at 175°C for 6 hours to obtain a cured product. The 5% weight loss temperature (°C) of the cured product in air was measured using a thermogravimetric differential thermal analyzer (Hitachi High-Tech Corporation "TG-DTA STA-7200"). The measurement temperature range was 40 to 600°C, and the heating rate was 10°C/min.

(Measurement of the Amount of Expansion)

A molded product of 4 mm × 4 mm × 20 mm was obtained using a transfer molding machine (Techno Maluchi Co., Ltd.) under conditions of a molding temperature of 175°C, a molding time of 120 seconds, and a molding pressure of 6.9 MPa. The obtained molded product was heated and cured at 175°C for 6 hours to obtain a cured product. Using a thermomechanical analysis apparatus (TA Instruments "TMA450"), a compressive load was applied and the displacement amount of the cured product was measured. The load was 0.1 N, the measurement temperature range was 30 to 260°C, and the heating rate was 10°C/min. The amount of expansion (μm) was obtained from the displacement amount (μm) at 30°C and the displacement amount (μm) at 260°C by the following formula.

Amount of expansion (μm) = Amount of displacement (μm) at 260°C - Amount of displacement (μm) at 30°C

(Measurement of Molding Shrinkage Rate)

Using a mold, a disc-shaped molded product (diameter of approximately 80 mm × thickness of approximately 4 mm) was molded using a transfer molding machine (Techno Maluchi Co., Ltd.) under conditions of a molding temperature of 175°C, a molding time of 120 seconds, and a molding pressure of 6.9 MPa, and then the molded product was allowed to cool to 25°C. After cooling to 25°C, the molded product was heated and cured in an oven heated to 175°C for 6 hours, and the obtained cured product was allowed to cool to 25°C. After cooling, the diameters of the front side and the back side of the cured product were measured, and the average value of the two measured values was defined as Rm (mm), and the inner diameter of the mold corresponding to the front of the cured product and the inner diameter of the mold corresponding to the back of the cured product were measured, and the average value of the two measured values was defined as Rd (mm). From Rm (mm) and Rd (mm), the molding shrinkage rate (%) was obtained by the following formula.

$$\text{Molding shrinkage rate (\%)} = (Rd - Rm) / Rd \times 100$$

(Measurement of Water Absorption Rate)

A disc-shaped molded product (diameter 50 mm × thickness 3 mm) was obtained using a transfer molding machine (Techno Maluchi Co., Ltd.) under conditions of a molding temperature of 175°C, a molding time of 120 seconds, and a molding pressure of 6.9 MPa. The obtained molded product was heated and cured at 175°C for 6 hours to obtain a cured product. Using a pressure cooker test apparatus (Hirayama Manufacturing Corporation), the cured product was subjected to pressure cooker treatment for 20 hours under conditions of a pressure of 2 atm (0.2 MPa), a temperature of 121°C, and a relative humidity of 100% RH. The mass of the cured product before and after the pressure cooker treatment was measured, and the water absorption rate (mass%) was obtained by the following formula.

Water absorption rate (mass%) = ((mass after treatment - mass before treatment) / mass before treatment) × 100

[Table 2]

Table 2

| | | | Example1 | Example2 | Example3 | Example4 | Example5 | Example6 | Example7 | Example8 | Example9 | Comparative Example 1 |
|---|---|---|---|---|---|---|---|---|---|---|---|---|
| Sealing material | Vinylphenyl compound | Vinylphenyl compound 1 | 100.0 | - | 49.1 | 64.0 | 73.0 | - | - | - | 6.8 | - |
| | | Vinylphenyl compound 2 | - | 100.0 | - | - | - | 50.6 | - | - | | - |
| | | Vinylphenyl compound 3 | - | - | - | - | - | - | 28.9 | 40.6 | 36.5 | - |
| | Vinyl compound | Vinyl compound 1 | - | - | 100.0 | - | - | - | 100.0 | - | - | - |
| | | Vinyl compound 2 | - | - | - | 100.0 | | 100.0 | - | 100.0 | 100.0 | 127.0 |
| | | Vinyl compound 3 | - | - | - | - | 100.0 | - | - | - | - | - |
| | Epoxy resin | Epoxy resin 1 | - | - | - | - | - | - | - | - | - | 80.0 |
| | | Epoxy resin 2 | - | - | - | - | - | - | - | - | - | 20.0 |
| | Phenolic resin | Phenolic resin | - | - | - | - | - | - | - | - | - | 115.0 |
| | Radical-polymerization initiator / Curing accelerator | Radical-polymerization initiator | 0.5 | 0.5 | - | - | - | - | - | - | - | - |
| | | Curing accelerator | - | - | - | - | - | - | - | - | - | 8.0 |
| | Coupling agent | Coupling agent 1 | 0.2 | 0.2 | 0.2 | 0.2 | 0.2 | 0.2 | 0.2 | 0.2 | 0.2 | 0.2 |
| | | Coupling agent 2 | 4.5 | 4.5 | 4.5 | 4.5 | 4.5 | 4.5 | 4.5 | 4.5 | 4.5 | 4.5 |
| | Releasing agent | Montanic acid ester wax | 1.0 | 1.0 | 1.0 | 1.0 | 1.0 | 1.0 | 1.0 | 1.0 | 1.0 | 1.0 |
| | Colorant | Carbon black | 2.3 | 2.3 | 2.3 | 2.3 | 2.3 | 2.3 | 2.3 | 2.3 | 2.3 | 2.3 |
| | Inorganic filler | Silica | 537 | 537 | 615 | 673 | 706 | 620 | 538 | 582 | 592 | 1393 |

(continued)

| | | Example1 | Example2 | Example3 | Example4 | Example5 | Example6 | Example7 | Example8 | Example9 | Comparative Example 1 |
|---|---|---|---|---|---|---|---|---|---|---|---|
| | Content ratio of inorganic filler [volume%] | 67 | 67 | 67 | 67 | 67 | 67 | 67 | 67 | 67 | 67 |
| | Vinyl phenyl group equivalent/-maleimide group equivalent | | | 0.7 | 0.4 | 0.4 | 0.4 | 0.4 | 0.4 | 0.4 | |
| Cured poduct | 5% Weight Loss Temperature (Td5)[°C] | 465 | 462 | 430 | 432 | 400 | 423 | 419 | 426 | 435 | 372 |
| | Amount of Expansion at 30°C to 260°C [μm] | 116 | 117 | 91 | 84 | 105 | 93 | 85 | 82 | 87 | 133 |
| | Molding shrinkage rate[%] | 0.23 | 0.22 | 0.15 | 0.19 | 0.24 | 0.18 | 0.13 | 0.11 | 0.15 | 0.27 |
| | Water absorption rate[%] | 0.1 | 0.1 | 0.2 | 0.3 | 0.1 | 0.2 | 0.3 | 0.4 | 0.2 | 0.5 |

**Claims**

1. A sealing material comprising a compound having a structural unit represented by the following formula (Bb1):

[Chem. 1]

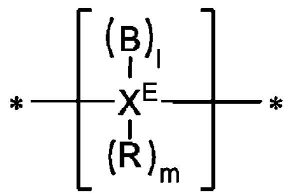

(Bb1)

(in the formula, $X^E$ represents an aromatic ring-containing organic group (wherein the organic group does not contain a structure represented by the following formula (X1) or (X2)), each B independently represents a vinyl phenyl group-containing group, 1 represents an integer of 1 to 5, each R independently represents a substituent, and m represents an integer of 0 to 10; * represents a bonding position with another atom;

[Chem. 2]

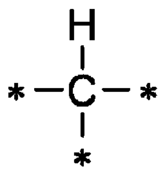

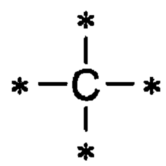

(X1) (X2)

(in the formula, * represents a bonding position with an atom other than a hydrogen atom)).

2. The sealing material according to claim 1, wherein the compound having a structural unit represented by the formula (Bb1) comprises a compound represented by the following formula (b2):

[Chem. 3]

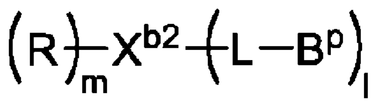

(b2)

(in the formula, $X^{b2}$ represents an aromatic hydrocarbon ring group, each $B^P$ independently represents a group represented by the following formula (Ph), each L independently represents a direct bond or a linking group, l represents an integer of 1 to 3, each R independently represents a substituent, and m represents an integer of 0 to 3;

[Chem. 4]

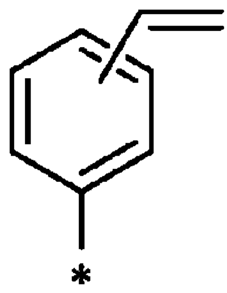

(P h)

(in the formula, * represents a bonding position)).

3. The sealing material according to claim 1 or 2, wherein the compound having a structural unit represented by the formula (Bb1) comprises a polymer represented by the following formula (B4):

[Chem. 5]

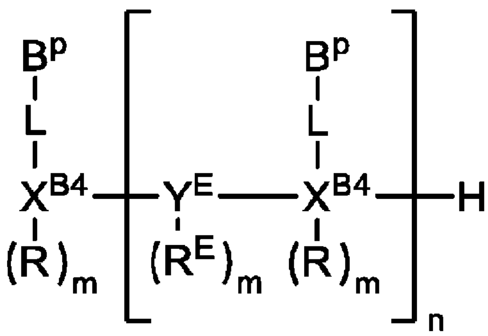

(B 4)

(in the formula, each $X^{B4}$ independently represents a benzene ring or a naphthalene ring, each $Y^E$ independently represents a group represented by any one of the following formulas (Y1) to (Y4), each $B^P$ independently represents a group represented by the following formula (Ph), each L independently represents a direct bond or a linking group, each R independently represents a substituent, each $R^E$ independently represents a substituent bonded to a benzene ring or a naphthalene ring, each m independently represents an integer of 0 to 5, and n represents a number of 2 to 10;

[Chem. 6]

$*-CH_2-*$ (Y1)

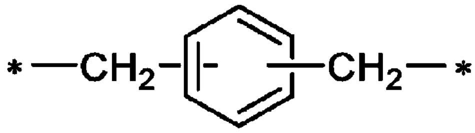

(Y2)

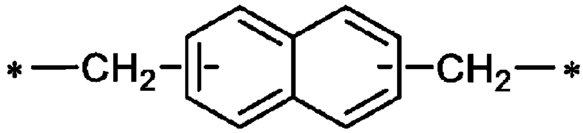

(Y3)

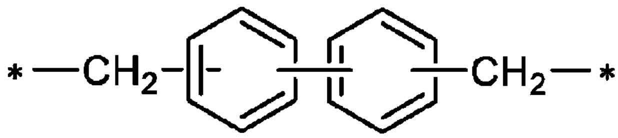

(Y4)

(in each formula, * represents a bonding position, and each of the benzene ring and the naphthalene ring may independently have a substituent at a substitutable position)

[Chem. 7]

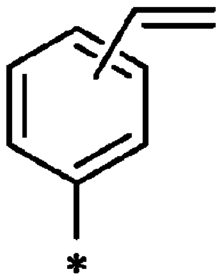

(Ph)

(in the formula, * represents a bonding position)).

4. The sealing material according to any one of claims 1 to 3, comprising a compound having a vinyl group.

5. The sealing material according to claim 4, wherein the compound having a vinyl group comprises a compound having a maleimide group.

6. The sealing material according to any one of claims 1 to 5, wherein the sealing material is a radically polymerizable sealing material.

7. A sealing member comprising a cured product obtained by using the sealing material according to any one of claims 1 to 6.

8. An electronic component device comprising the sealing member according to claim 7.

9. A semiconductor device comprising a semiconductor element and the sealing member according to claim 7, wherein the sealing member seals at least a part of the semiconductor element.

10. A semiconductor module comprising a plurality of members selected from a group consisting of a semiconductor

element and a semiconductor device; and the sealing member according to claim 7, wherein the sealing member seals at least a part of the plurality of members.

## INTERNATIONAL SEARCH REPORT

International application No.
**PCT/JP2024/027905**

### A. CLASSIFICATION OF SUBJECT MATTER

***H01L 23/29***(2006.01)i; ***H01L 23/31***(2006.01)i; ***C08F 32/08***(2006.01)i; ***C08F 290/14***(2006.01)i; ***C08G 8/30***(2006.01)i; ***C09K 3/10***(2006.01)i
FI: H01L23/30 R; C08G8/30; C08F32/08; C08F290/14; C09K3/10 Z

According to International Patent Classification (IPC) or to both national classification and IPC

### B. FIELDS SEARCHED

Minimum documentation searched (classification system followed by classification symbols)

H01L23/29; H01L23/31; C08F32/08; C08F290/14; C08G8/30; C09K3/10

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2005-314556 A (NIPPON KAYAKU KABUSHIKI KAISHA) 10 November 2005 (2005-11-10) claims, paragraphs [0005], [0037]-[0043] | 1, 3-10 |
| Y | | 1-2, 4-10 |
| X | WO 2021/251052 A1 (DIC CORPORATION) 16 December 2021 (2021-12-16) claims, paragraphs [0089]-[0099] | 1, 3-10 |
| Y | | 1-2, 4-10 |
| Y | JP 2003-277440 A (SHOWA HIGHPOLYMER CO., LTD.) 02 October 2003 (2003-10-02) claims, paragraphs [0005], [0044]-[0046], [0052] | 1-2, 4-10 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **08 October 2024** | **15 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/027905**

| Patent document cited in search report | Publication date (day/month/year) | Patent family member(s) | Publication date (day/month/year) |
|---|---|---|---|
| JP 2005-314556 A | 10 November 2005 | (Family: none) | |
| WO 2021/251052 A1 | 16 December 2021 | US 2023/0272156 A1<br>claims, paragraphs [0076]-[0095]<br>KR 10-2023-0022397 A<br>CN 115836101 A<br>TW 202146499 A | |
| JP 2003-277440 A | 02 October 2003 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021130743 A
- JP 2023128624 A